# EUROPEAN PATENT APPLICATION

(11) **EP 4 535 405 A1**
(43) Date of publication of application: **09.04.2025**
(21) Application number: 23816125.1
(22) Date of filing: 31.05.2023
(51) Int. Cl.: H01L 21/312, H01L 21/316

(54) **SUBSTRATE PROCESSING METHOD AND SUBSTRATE PRODUCTION METHOD**

(30) Priority: 02.06.2022 JP 2022090143
(71) Applicant: Central Glass Company, Limited, Ube-shi, Yamaguchi 755-0001 (JP)
(72) Inventor: TANIGUCHI Takahisa, Tokyo 101-0054 (JP); LIN Chih-Chien, Tokyo 101-0054 (JP); MIYAZAKI Tatsuo, Tokyo 101-0054 (JP); OKUMURA Yuzo, Tokyo 101-0054 (JP); TERUI Yoshiharu, Tokyo 101-0054 (JP)
(74) Representative: Mewburn Ellis LLP
(86) International application number: PCT/JP2023/020344
(87) International publication number: WO 2023/234368

(57) **Abstract**

A substrate processing method according to the present invention includes: a preparation step of preparing a substrate that has, on a surface thereof, a first surface which contains Si and a second surface which has a different chemical composition from the first surface and which contains Si; a surface modification step of carrying out a silylation treatment of bringing a silylating agent into contact with the first surface and the second surface and then carrying out a water repellency adjustment treatment of selectively decreasing water repellency of the second surface with respect to the first surface; and a processing step of selectively carrying out a processing treatment with respect to the second surface after the surface modification step.

## Description

### TECHNICAL FIELD

The present invention relates to a substrate processing method and a substrate manufacturing method.

### BACKGROUND ART

In the related art, fine patterning has been carried out by a plurality of lithography treatments or etching treatments in order to obtain a semiconductor device. However, in recent years, there has been a tendency for semiconductor devices to be more highly integrated and miniaturized, and there has been such a problem that, in a case where an attempt is made to satisfy these requirements, the lithography treatment tends to be complicated and costly. Therefore, there is a demand for an alternative technique as a substitute for the lithography technique.

As an alternative technique as a substitute for the lithography technique, a technique using a self-assembled monolayer (SAM) has been studied. Specifically, it is a technique of selectively depositing a self-assembled monolayer (hereinafter, simply referred to as a "monolayer") as a mask material or a protective material in a substrate region which is a non-treatment target, and subjecting a desired film material to a film formation or deposition in a remaining region (that is, a region which is a treatment target) of the substrate or carrying out an etching treatment.

Various methods have been studied as the method of selectively depositing the monolayer, and for example, there is a method of selectively forming a monolayer based only on the chemical properties of the surface of the substrate. In such a method, a combination of the non-treatment target and the treatment target is not particularly limited as long as the monolayer can be selectively formed. Therefore, various studies have been made on a method of forming a monolayer corresponding to such a combination. As such a technique, for example, techniques described in Patent Documents 1 to 3 are known.

For example, Patent Document 1 discloses a method of supplying a protective film forming gas including an amine gas to a substrate having a surface on which a first film and a second film having respective properties of being etched by an etching gas are formed, thereby adsorbing an amine on the first film to selectively protect the first film, and then selectively etching the second film. In the claims of this document, as the combination of the first film and the second film, each of a combination of a silicon oxide film and a silicon film and a combination of an SiOCN film and a silicon oxide film is disclosed, and as the protective film forming gas, hexylamine, dipropylamine, n-octylamine, butylamine, tert-butylamine, decylamine, dodecylamine, dicyclohexylamine, tetradecylamine, and the like are exemplified.

Patent Document 2 discloses a method of forming a SAM on vertical spacers as a blocking material and then selectively forming a high-k film on a nanowire between the vertical spacers and a metal-containing gate electrode layer on the high-k film. In this document, it is described that the vertical spacer includes a SiCOH material, a dielectric material having a relative dielectric constant of less than approximately 7, or an air gap spacer and that the nanowire is composed of Si, SiGe, or both of Si and SiGe. In addition, as a terminal group of a molecule that forms the SAM, thiol, silane, and phosphonate are exemplified.

Patent Document 3 discloses a method of exposing a substrate having a surface containing silicon, which contains Si, SiN, a silicon thermal oxide or the like, and a surface not containing silicon, which contains W, Co, TiN, TaN, or the like to a surface treatment agent containing a silylating agent and a nitrogen-containing heterocyclic compound, thereby carrying out the surface silylation. In this document, a water repellent film is formed on the surface by the silylation; however, a water contact angle after the silylation varies depending on the material of the surface, thus it is proposed to use a difference in the water contact angle to form a film according to an atomic layer deposition (hereinafter, simply referred to as "ALD") method, on a desired surface, that is, on a surface on which a water repellent film is less likely to be formed.

### RELATED DOCUMENT

### PATENT DOCUMENT

Patent Document 1: PCT Japanese Translation Patent Publication No. 2021-163775
Patent Document 2: PCT Japanese Translation Patent Publication No. 2021-528859
Patent Document 3: Japanese Unexamined Patent Publication No. 2019-121777

### SUMMARY OF THE INVENTION

### TECHNICAL PROBLEM

Such a method of forming a water repellent film as a monolayer by surface silylation, as disclosed in Patent Document **3,** is useful since a film is easily formed on a surface having silicon (hereinafter, referred to as a "Si-based surface").

However, in a case where the water repellent film is selectively formed between the first surface and the second surface (for example, between a silicon surface and a silicon oxide surface, or between a silicon oxide surface and a silicon nitride surface), which are Si-based surfaces, for example, in a case where the water repellent film is intended to be formed on one Si-based surface (first surface) but the water repellent film is not intended to be formed on the other Si-based surface (second surface) having a different chemical composition, it tends to be difficult to form a selective water repellent film since each of these two surfaces has reactivity with a silylating agent.

An object of the present invention is to realize a substrate processing method having excellent selective processability between a first surface and a second surface, which are Si-based surfaces.

### SOLUTION TO PROBLEM

According to one aspect of the present invention, there are provided a substrate processing method and a substrate manufacturing method, which are as follows.
1. A substrate processing method including:
   a preparation step of preparing a substrate that has, on a surface thereof, a first surface which contains Si and a second surface which has a different chemical composition from the first surface and which contains Si;
   a surface modification step of carrying out a silylation treatment of bringing a silylating agent into contact with the first surface and the second surface and then carrying out a water repellency adjustment treatment of selectively decreasing water repellency of the second surface with respect to the first surface; and
   a processing step of selectively carrying out a processing treatment with respect to the second surface after the surface modification step.
2. The substrate processing method according to 1.,
   in which in the surface modification step, a pretreatment is carried out before the silylation treatment, and
   in which the pretreatment includes a treatment A-1 of removing a natural oxidation film on at least the first surface and/or a treatment A-2 of bonding OH to at least a part of Si on the first surface.
3. The substrate processing method according to 2., in which the treatment A-2 is a treatment A-2a of bringing an active species containing an oxygen element and/or a gas containing an oxygen element into contact with at least the first surface, or a treatment A-2b of bringing an oxidizing agent containing an oxygen element into contact with at least the first surface.
4. The substrate processing method according to 3., in which the treatment A-2a is at least one selected from the group consisting of a plasma treatment using a plasma containing an oxygen element, a UV/O₃ treatment, and a gas treatment of carrying out exposure to a gas containing an oxygen element.
5. The substrate processing method according to 3., in which the oxidizing agent includes a solution containing H₂O₂, and/or ozone water.
6. The substrate processing method according to any one of 1. to 5., in which the water repellency adjustment treatment includes a removal treatment of removing, by using a removing agent, at least a part of compounds derived from the silylating agent, which are chemically or physically bound to the second surface.
7. The substrate processing method according to 6., in which the removing agent includes at least one selected from the group consisting of ammonia, an organic amine, a quaternary ammonium hydroxide, and hydrogen fluoride.
8. The substrate processing method according to any one of 1. to 7., in which in a case where a value of a water contact angle on the first surface is denoted as S1 and a value of a water contact angle on the second surface is denoted as S2 immediately before the processing step after the surface modification step, (S1 - S2)/S2 is 1.0 or more.
9. The substrate processing method according to any one of 1. to 8.,
   in which in a case where the first surface is silicon oxide, the second surface is silicon, or alternatively, a compound formed between Si and at least one selected from the group consisting of N, C, and a metal element, or an oxide of the compound,
   in a case where the first surface is silicon, the second surface is a compound formed between Si and at least one selected from the group consisting of N, C, and a metal element, or an oxide of the compound, and
   in a case where the first surface is a compound formed between Si and at least one selected from the group consisting of N and C, or an oxide of the compound, the second surface is a compound formed between Si and a metal element, or an oxide of the compound.
10. The substrate processing method according to any one of 1. to 9., in which in the processing step, the processing treatment includes a film forming treatment of forming a film on the second surface by an atomic layer deposition method and/or an etching treatment of etching the second surface.
11. The substrate processing method according to any one of 1. to 10., in which in the silylation treatment, the silylating agent is used, or a silylation composition containing the silylating agent is used.
12. The substrate processing method according to 11., in which the silylation composition contains at least one of a solvent, a dilution gas, or a catalytic compound.
13. The substrate processing method according to any one of 1. to 12., in which the surface modification step includes a cleaning treatment of cleaning at least a part of the second surface with a cleaning agent.
14. The substrate processing method according to 13., in which the cleaning agent includes an aqueous cleaning solution and/or a rinsing solution.
15. A substrate manufacturing method including:
   a step of obtaining a substrate on which each step in the substrate processing method according to any one of 1. to 14.
has been carried out.

### ADVANTAGEOUS EFFECTS OF INVENTION

According to the present invention, there are provided a substrate processing method having excellent selective processability between a first surface and a second surface, which are Si-based surfaces, and a substrate manufacturing method using the substrate processing method.

### BRIEF DESCRIPTION OF THE DRAWINGS

Fig. 1 is a step cross-sectional view schematically showing each step of a substrate processing method according to the present embodiment.
Fig. 2 is a step cross-sectional view schematically showing each step of the substrate processing method according to the present embodiment.
Fig. 3 is a step cross-sectional view schematically showing each step of the substrate processing method according to the present embodiment.

### DESCRIPTION OF EMBODIMENTS

Hereinafter, embodiments of the present invention will be described with reference to the drawings. It is noted that in all the drawings, the same constitutional elements are denoted as the same reference numerals and explanations thereof will not be repeated, as appropriate. In addition, the figures are schematic views and do not correspond to the actual dimensional ratios.

### <Substrate processing method>

An outline of the substrate processing method according to the present embodiment will be described.

A substrate processing method according to the present embodiment includes a preparation step of preparing a substrate that has, on a surface thereof, a first surface which contains Si and a second surface which has a different chemical composition from the first surface and which contains Si; a surface modification step of carrying out a silylation treatment of bringing a silylating agent into contact with the first surface and the second surface and then carrying out a water repellency adjustment treatment of selectively decreasing water repellency of the second surface with respect to the first surface; and a processing step of selectively carrying out a processing treatment with respect to the second surface after the surface modification step.

According to the knowledge of the inventors of the present invention, it has been found that, by a surface modification step of subjecting two Si-based surfaces (first surface and second surface), which contain a Si element but have chemical compositions different from each other, to a silylation treatment and then carrying out a water repellency adjustment treatment of selectively reducing the water repellency on one second surface with respect to the other first surface, it is possible to carry out a selective processing treatment such as a selective film formation using an ALD method or a selective etching treatment with respect to the second surface.

It is noted that in the present specification, the phrase "have chemical compositions different from each other" on the Si-based surface includes, for example, a case where an element other than silicon, which is contained in the first surface, is different from an element other than silicon, which is contained in the second surface, and a case where a content rate of an element contained in the first surface is substantially different from a content rate of an element contained in the second surface.

In general, the first surface and the second surface, which are Si-based surfaces, each have reactivity with a silylating agent, and thus it tends to be difficult to form a water repellent film on only one of the surfaces.

On the other hand, according to the present embodiment, by carrying out the water repellency adjustment treatment of selectively reducing the water repellency of the desired Si-based surface, it is possible to make a state in which a Si-based surface (first surface) on which a water repellent film has been formed, and a Si-based surface (second surface) on which a water repellent film has not been formed or on which water repellency is very low coexist between a plurality of two or more of Si-based surfaces. It is noted that it has been found by the studies of the inventors of the present inventions that in a case where the water repellency is extremely low, the function as a protective film is also extremely low although it is not revealed whether the water repellent film is present or absent. As described above, by making such a coexisting state as described above, the water repellent film functions as the protective film, and thus the Si-based surface having a smaller water repellency is selectively subjected to the processing treatment, whereby it is possible to realize a substrate processing method having excellent selective processability between the first surface and the second surface, which are Si-based surfaces.

It is noted that in the "water repellent film" in the present specification, both a compound having a silyl group derived from a silylating agent chemically bonded to the Si-based surface and a group of such compounds are referred to, and the presence or absence of interaction between the compounds or the presence or absence of bonding between the compounds does not matter. In addition, the above-described water repellent film may contain a compound derived from a silylating agent, which has been subjected to physical binding (adsorption, attachment, or the like) to the Si-based surface. It is noted that the above-described binding is not required to be a direct bonding and includes a case of bonding through another element, a substituent, or the like.

### (Water repellency)

For the water repellency in the present specification, a water contact angle obtained by the following measurement is used. It is noted that details of the cleaning, drying, or the like before each measurement will be described later.

First, a substrate was placed horizontally such that a desired Si-based surface was facing upward, and 2 µl of a water droplet of pure water was placed on the surface. It is noted that in order to suppress the influence of the surface shape on the water contact angle, a substrate having a smooth surface on which a water droplet is placed is used. Next, in accordance with JIS R 3257:1999 "Testing method of wettability of surface of glass substrate", the temperature during the measurement was set to room temperature (25°C), an angle formed by a water droplet and the substrate was measured with a contact angle meter (manufactured by Kyowa Interface Science Co., Ltd.: CA-X type), and the obtained value was defined as a water contact angle.

Hereinafter, each step included in the substrate processing method will be described in detail.

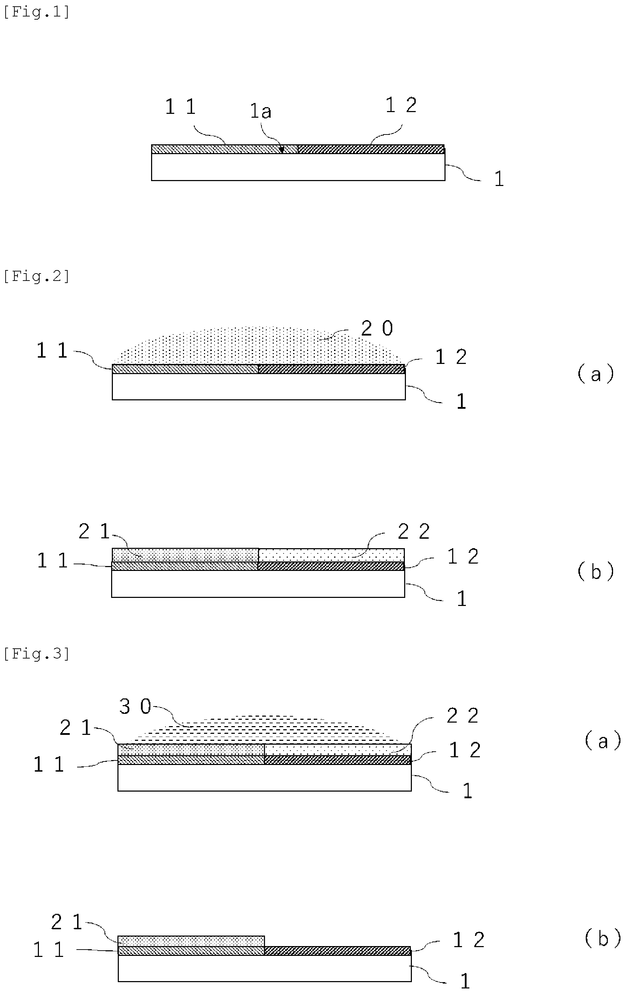

An example of the substrate processing method according to the present embodiment includes a preparation step, a surface modification step, and a processing step, which will be described with reference to Fig. 1 to Fig. 3. Fig. 1 to Fig. 3 are each a step cross-sectional view schematically showing each of the steps of the substrate processing method.

### (Preparation step)

As shown in Fig. 1, in the above-described preparation step, a substrate 1 that has, on a surface thereof, a first surface 11 and a second surface 12 is prepared.

A material of the substrate 1 is not particularly limited as long as it is a substrate that is used in a semiconductor manufacturing process. The material of the substrate 1 may be composed of, for example, silicon, silicon carbide, a plurality of components containing a silicon element, sapphire, various compound semiconductors, or the like. In addition, the substrate 1 may be, for example, a wafer.

The substrate 1 may have an uneven structure (not shown in the drawing) formed on the substrate surface.

The uneven structure may be composed of a three-dimensional structure having, for example, one or two or more structural bodies disposed along a vertical direction of a substrate surface 1a and/or one or two or more structural bodies disposed along a horizontal direction orthogonal to the vertical direction. As an example, such a three-dimensional structure may constitute at least a part of a logic device, a memory device, a gate electrode, or the like, and examples thereof include a FinFET, a nanowire FET, a nanosheet FET, or another multi-gate type FET, and a three-dimensional memory cell.

Each of the first surface 11 and the second surface 12 may be disposed along the plane direction of the substrate surface 1a; however, it may be disposed along a direction perpendicular to the substrate surface 1a. According to the present embodiment, it is possible to carry out not only a two-dimensional selective processing treatment on a plane but also a three-dimensional selective processing treatment on a three-dimensional structure (three-dimensional film formation, three-dimensional etching, or the like).

The first surface 11 and the second surface 12 may be formed to be adjacent to each other; however, they may be formed to be spaced from each other. Each of the first surface 11 and the second surface 12 may be composed of one region or a plurality of two or more regions. On each surface, a plurality of regions may be formed to be spaced apart from each other.

Examples of the material constituting the first surface 11 and the second surface 12 include the following materials.

Examples of such a material include (1) silicon (polysilicon or single crystal silicon), (2) silicon oxide, and (3) a compound formed between Si and at least one selected from the group consisting of N, C, and a metal element, or an oxide of the compound.

The metal element in (3) may be any metal element or metalloid element which is usually used in a semiconductor material, and examples thereof include W, Co, Al, Ni, Ru, Cu, Ge, Ti, Hf, and Ta. In addition, examples of the compound with Si, which contains N or C, include compounds such as silicon nitride, silicon carbide, and silicon carbonitride, and compounds formed between these compounds and the above metal elements, and examples of the oxide include oxides of these compounds.

Each of the materials in (1) to (3) may contain an element (H, P, B, and the like) other than Si, N, C, and O.

It is noted that the term "oxide" described above refers to a state in which oxygen is bonded to another constitutional material (particularly, Si) and is contained to such an extent that affects some kind of properties, and it does not include a case where a small amount of the oxygen is present to such an extent that does not affect physical properties. In addition, the term "compound" refers to a state in which an element other than oxygen is bonded to another constitutional material (particularly, Si) and is contained to such an extent that affects some kind of properties, and it does not include a case where a small amount of the element other than oxygen is present to such an extent that does not affect physical properties.

In addition, in the preparation step according to the present disclosure, in a case where a surface layer of the surface of each of the materials in (1) or (3) described above is naturally oxidized unintendedly, the materials may be used as materials which are not naturally oxidized (for example, naturally oxidized silicon is treated as silicon) may be used.

An example of a combination of the composition materials of the first surface 11 and the second surface 12 will be described.

For example, in a case where the first surface 11 is silicon oxide, the second surface 12 may be composed of silicon, or alternatively, a compound formed between Si and at least one selected from the group consisting of N, C, and a metal element, or an oxide of the compound.

In addition, in a case where the first surface 11 is silicon, the second surface 12 may be composed of a compound formed between Si and at least one selected from the group consisting of N, C, and a metal element, or an oxide of the compound.

In addition, in a case where the first surface 11 is a compound formed between Si and at least one selected from the group consisting of N and C, or an oxide of the compound, the second surface 12 may be composed of a compound formed between Si and a metal element, or an oxide of the compound.

The first surface 11 and the second surface 12 may be a surface of a member composed of the above-described material, or may be composed of a surface of a film that is obtained by subjecting the above-described material to film formation. In particular, in a case where a surface is composed of a film, the surface may contain two or more elements other than Si in the above-described material. Examples of the film containing two or more elements other than Si include a general low-k film such as SiON, SiCN, SiCO, SiCOH, and SiOCN. It is noted that the composition of the above-described film is merely described representatively, and the stoichiometric ratio thereof is not necessarily the integer ratio as described. Specifically, in a case of SiON, Si:O:N is not limited to 1:1:1.

The water repellency of each of the first surface 11 and the second surface 12 is usually a property peculiar to the composition material constituting the surface; however, it can be adjusted by a pretreatment, a silylation treatment, a removal treatment, or the like, which will be described later. For example, in a case where the silylation treatment is carried out, the water repellency (water contact angle or the like) tends to be improved as compared with the original water repellency, and in a case where the removal treatment is carried out, the water repellency improved by the silylation treatment may be reduced. In addition, by the pretreatment, it is possible to enhance or weaken the effect of the silylation treatment or the removal treatment. Since the above-described tendency varies depending on the composition material constituting the surface, it is possible to appropriately adopt the first surface 11, which is a target of protection from the processing treatment, and the second surface 12, which is a target of the processing treatment, by considering the combination of each of the treatments and the water repellency immediately after these treatments. It is noted that even in a case where a water repellent film is formed on the surface by the silylation treatment of the first surface 11 or the second surface 12 and "the water repellency of the surface" actually means "the water repellency of the water repellent film", it is described as "the water repellency of the first surface" or "the water repellency of the second surface". In addition, even in a case where at least a part of the surface layer of each of the surfaces is oxidized or reduced by the pretreatment, the removal treatment, or the like, which will be described later, such substrates are treated as the first surface 11 and the second surface 12, which are prepared in the preparation step.

It is noted that a trace amount of one kind or two or more kinds of dopants (for example, P, N, B, Al, and the like) that is used for an n-type source drain or a p-type source drain may be contained in the first surface 11 and the second surface 12 or in the substrate 1 in the lower peripheral region of each of the first surface 11 and the second surface 12. Since the addition of a trace amount of the above-described dopant with respect to the content of the Si element can affect the electrical properties, it is presumed that any content at a level that allows a function as a dopant does not affect the silylation on the first surface 11 or the second surface 12.

The substrate 1 may further include a third surface and/or a fourth surface (not shown in the drawing) on the substrate surface 1a.

The third surface is a surface which contains Si and is composed to have a chemical composition different from those of the first surface 11 and the second surface 12.

The fourth surface is a surface that does not contain Si, and it is, for example, a surface composed of amorphous carbon, an element such as W, Co, Al, Ni, Ru, Cu, Ti, or Ta, or a compound, oxide, nitride, or the like of these elements. The fourth surface may be a film surface of a High-k film.

Each of the third surface and the fourth surface may be adjacent to each other, or may be formed to be spaced from each other with respect to the first surface 11 and/or the second surface 12. In addition, each of the third surface and the fourth surface may be composed of one region or a plurality of two or more regions.

### (Surface modification step)

The surface modification step includes a silylation treatment of the substrate surface and a water repellency adjustment treatment after the silylation treatment. As described above, the water repellency adjustment treatment selectively reduces the water repellency of the second surface of the substrate with respect to the water repellency of the first surface. In other words, the reduction of the water repellency of the first surface of the substrate may be suppressed or may be maintained. In this case, for the intended purpose of improving the effect of the silylation treatment on the first surface or making the water repellency of the second surface lower, a separate treatment may be carried out before and after the silylation treatment. In addition, even in a case where the water repellency of the first surface is higher than the water repellency of the second surface at a time immediately after the silylation treatment, it is possible to easily carry out a selective processing treatment on the second surface in a processing step described later, by carrying out the water repellency adjustment treatment to further reduce the water repellency of the second surface.

An example of the above-described surface modification step includes subjecting the substrate 1 shown in Fig. 1 to a pretreatment and then subjecting the substrate 1 to a silylation treatment and a removal treatment as shown in Fig. 2 and Fig. 3.

In the present specification, pretreatment / silylation treatment / removal treatment may be respectively referred to as pretreatment A / silylation treatment B / removal treatment C, or treatment A / treatment B / treatment C.

It is noted that a part or all of the treatment A to the treatment C may be carried out in a wet process or may be carried out in a dry process. In addition, the treatment A to treatment C described above may be such that the first surface 11 and the second surface 12 may be treated separately or may be carried out at the same time; however, it is convenient to carry out the treatments simultaneously as shown in Fig. 1, which is preferable.

In addition, in a case where favorable results are obtained by the silylation treatment B and the removal treatment C even without carrying out the pretreatment A, the pretreatment A may not be carried out.

In the surface modification step, in a case where the pretreatment A is carried out before the silylation treatment B, the pretreatment A may include a treatment A-1 of removing a natural oxidation film on at least the first surface 11 and/or a treatment A-2 of bonding OH to at least a part of Si on the first surface 11.

It suffices that the pretreatment A is carried out on at least the first surface 11; however, it may be carried out on the first surface 11 and the second surface 12. However, even in a case where the treatment A is carried out, the natural oxidation film may not be removed in a part or all of the second surface 12, and the OH group may not be formed on the surface depending on the composition material.

In addition, the above-described treatment A-2 may include a treatment A-2a of bringing an active species containing an oxygen element and/or a gas containing an oxygen element into contact with at least the first surface 11, or a treatment A-2b of bringing an oxidizing agent containing an oxygen element into contact with at least the first surface 11.

The treatment A-1 is not particularly limited as long as it is a treatment that is capable of removing the natural oxidation film. In general, in a semiconductor manufacturing process, a natural oxidation film is formed on a surface of polysilicon, silicon oxide, or the like. This natural oxidation film can be removed by the treatment A-1, which is preferable. It is noted that although it is not necessary to carry out the treatment A-1 in a case of a surface on which the natural oxidation film is not formed, the operation of the treatment A-1 may be carried out as a part of the cleaning.

Examples of the specific method for the treatment A-1 include a method of bringing hydrofluoric acid (HF) into contact with the first surface 11 and the second surface 12, a method of bringing a diluted hydrofluoric acid (DHF) into contact with the first surface 11 and the second surface 12, and a method of reacting a mixed gas containing HF gas and NH₃ gas with the first surface 11 and the second surface 12. The specific method for contacting may be a publicly known method, and examples thereof include the same method as the silylation treatment B described later, and a publicly known dry process treatment. It is noted that after the contact with the hydrofluoric acid, a cleaning treatment may be carried out with a cleaning agent described later.

The treatment A-2 is not particularly limited as long as it is a method of forming an OH group on the surface of the first surface 11; however, it is desirable to adopt an appropriate treatment for the desired Si-based surface since the behavior of the ease of silylation by the silylation treatment B or the ease of water repellency reduction by the removal treatment C may vary depending on the strength of the oxidizing power in a case of forming the OH group. Examples of the treatment A-2 include the treatment A-2a and the treatment A-2b. By the treatment A-2, an OH group-containing region may be newly formed, or a film having an OH group (Si-OH coating film) may be formed on the first surface 11. The OH group on the first surface 11 serves as a point for reaction with a silylating agent in the following silylation treatment B.

The treatment A-2a is a treatment that easily oxidizes the Si-based surface as compared with the treatment A-2b. In the treatment A-2a, an active species containing an oxygen element or a gas containing an oxygen element is brought into contact with at least the first surface 11. As a specific method for the treatment A-2a, a publicly known oxidation treatment that is used in a dry process can be suitably used, and examples thereof include at least one selected from the group consisting of a plasma treatment using a plasma containing an oxygen element, a UV/O₃ treatment, and a gas treatment of carrying out exposure to a gas containing an oxygen element. Since the Si-based surface is easily oxidized in the treatment A-2a, the OH group can be formed on the first surface 11 without going through the treatment A-1, even in a case where a natural oxidation film is formed on the surface.

In addition, the above-described plasma treatment may be carried out by a publicly known method, and examples thereof include an O₃ plasma treatment, an O₂ plasma treatment, a CO₂ plasma treatment, a CO plasma treatment, a NO₂ plasma treatment, a NO plasma treatment, and a H₂O plasma treatment.

In addition, the UV/O₃ treatment is a treatment of generating a radical containing an oxygen element to carry out oxidization, where a publicly known treatment device can be used.

In addition, examples of the gas that is used in the above-described gas treatment include O₃, O₂, CO₂, and H₂O₂, and a heated gas may be used for the intended purpose of efficiently carrying out oxidation.

The treatment A-2b is a treatment that is capable of gently oxidizing the Si-based surface as compared with the treatment A-2a. In the treatment A-2b, an oxidizing agent containing an oxygen element is brought into contact with at least the first surface 11.

As the above-described oxidizing agent, a gas containing an oxygen element, which has an oxidizing power not as strong as that of the treatment A-2a, may be used, or the same gas may be used under weak oxidation conditions. However, it is preferable to use a liquid oxidizing agent due to the fact that the strength of the oxidation is easily adjusted. Examples of the liquid oxidizing agent described above include a solution containing H₂O₂ and/or ozone water. In addition, examples of the solution containing H₂O₂ include such a cleaning agent that is used for cleaning a silicon wafer or the like (an alkaline mixed liquid of H₂O₂ and ammonium hydroxide (SC-1 solution), an acidic mixed liquid of H₂O₂ and hydrochloric acid (SC-2 solution), or the like) and an H₂O₂ aqueous solution. The specific method for contacting may be a publicly known method, and examples thereof include the same method as the silylation treatment B described later.

It is noted that, as necessary, the treatment A-1 may be carried out before the treatment A-2b to remove the natural oxidation film in advance. In addition, the treatment A-2a and the treatment A-2b may be used in combination.

As shown in Fig. 2(a), in the silylation treatment B, a silylating agent described later is brought into contact with at least the first surface 11 and the second surface 12. In the silylation treatment B, the silylating agent may be used alone; however, it is possible to use a silylating agent and a silylation composition containing a solvent or a dilution gas, or alternatively, a silylating agent and a catalytic compound, or a silylation composition containing, as necessary, a solvent or a rare gas. The silylating agent or the silylation composition can be used in a liquid or gaseous state.

In a case of the wet process, a liquid of a silylating agent 20 or a liquid of a silylation composition 20 is supplied to the first surface 11 and the second surface 12. As the supply method, a publicly known means can be used, and examples thereof include, in a case of supply in a liquid state, a sheet feeding method such as a spin coating method, and a batch method such as an immersion method. In addition, in a case where a vapor is supplied and then made into a liquid after being brought into contact with the first surface 11 and the second surface 12, a publicly known vapor jetting method can be used.

In a case of a dry process, the silylating agent is supplied to the first surface 11 and the second surface 12 as a gas. As the supply method, a publicly known means can be used, and examples thereof include a method of gasifying the silylating agent in advance using a vaporizer or the like and then supplying the gas, and a method of allowing the silylating agent to flow simultaneously together with an inert gas such as N₂ and Ar, thereby being accompanied and supplied. In addition, two or more kinds of gases may be simultaneously supplied or may be mixed in advance and then supplied.

By the silylation treatment B, at least the water repellency of the first surface 11 can be improved. In addition, in this case, the water repellency of the second surface 12 may be increased.

By the above-described silylation treatment B, a structure in which the silyl group derived from the silylating agent is chemically bonded to the OH group of the first surface 11, that is, a water repellent film is formed on the first surface 11, and the water repellency is improved. In addition, a water repellent film may also be formed on the second surface 12, and thus even in a case where the water repellent film is not formed, the water repellency may be increased since a structure in which a compound derived from the silylating agent is subjected to physical binding (for example, attachment or adsorption) to the surface is provided.

As an example, as shown in Fig. 2(b), a water repellent film 21 may be formed on the first surface 11, and a water repellent film 22 may be formed on the second surface 12. Each of the water repellent film 21 and the water repellent film 22 may be composed of a film that covers at least a part or the entire surface.

It is noted that the water repellent film 22 does not necessarily have to be formed on the second surface 12. In order to easily reduce the water repellency of the second surface 12 in the water repellency adjustment treatment, it is preferable that the water repellent film 22 is formed on a part of the second surface 12 or a compound derived from the silylating agent is allowed to have a state in which the compound physically may bind to the second surface 12.

The improvement in the water repellency by the silylation treatment B can be estimated by comparing the water repellency immediately before the silylation treatment B and the water repellency immediately after the silylation treatment B. Specifically, it can be presumed that a water repellent film derived from the silylating agent tends to be formed in a case where a silylation rate represented by (R - P)/P is large (for example, 5.0 or more) in a case where a value (°) of the water contact angle immediately after the silylation treatment B is denoted as R and a value (°) of the water contact angle immediately before the silylation treatment B is denoted as P.

In addition, in a case where the silylation rate described above is low (for example, less than 5.0), it can be presumed that the water repellent film derived from the silylating agent tends to be formed only on a part of the surface, or the proportion of the compound derived from the silylating agent to be physically bound tends to be high. It is noted that regarding the phrase "the water contact angle immediately before the silylation treatment B" described above, a water contact angle on a surface that has not been subjected to silylation is used, and in a case of carrying out the silylation treatment B a plurality of times, a water contact angle immediately before the first silylation treatment B is used.

In a case where the point for reaction with the silylating agent can be increased on the first surface 11 by the pretreatment A, the silylation reaction can be promoted in the silylation treatment B. In addition, the silylation rate described above can be improved by increasing the Si-OH bond on the surface through the pretreatment A-2a or the pretreatment A-2b, and it is possible to form a water repellent film more easily, which is suitable in a case of desiring the surface to be the first surface.

As necessary, a publicly known means such as a heating treatment, a decompression treatment, and a drying treatment may be applied to the silylation treatment B to promote the silylation reaction between the silylating agent and the OH group of the surface.

The removal treatment C refers to, for example, as shown in Fig. 3(b), a treatment of removing a compound derived from the silylating agent, which has been chemically/physically bound to at least a part of the second surface 12, such as the water repellent film 22 present on the second surface 12, while allowing the water repellent film 21 on the first surface 11 to remain. In a case where the water repellency adjustment treatment includes such a removal treatment C, it is possible to selectively reduce the water repellency on the second surface 12 with respect to the first surface 11.

As a method for the removal treatment C, for example, as shown in Fig. 3(a), a method of removing, by using a removing agent, at least a part of compounds derived from the silylating agent, which are chemically or physically bound to the second surface 12 is used.

Examples of the specific method for the removal treatment C include a method of bringing a liquid removing agent into contact with the first surface 11 and the second surface 12. In addition, in a case where the water repellent film 21 on the first surface 11 can be allowed to remain, a gaseous removing agent such as gas may be used. It is noted that the phrase "bringing into contact with the first surface 11 and the second surface 12" refers to bringing into contact with at least the water repellent film 21 and the water repellent film 22 in a case where the water repellent film 21, the water repellent film 22, or the like are formed.

In addition, a specific method for bringing a removing agent into contact may be a publicly known method, and examples thereof include the same method as the silylation treatment B described above.

As the removing agent, for example, a removing agent including at least one selected from the group consisting of ammonia, an organic amine, a quaternary ammonium hydroxide, and hydrogen fluoride can be used. In addition, in a case where two or more of the above-described substances are used, a case where the substances form a salt is also included. In a case where a solution, which contains, among the above, at least one selected from the group consisting of hydrogen fluoride, triethylamine, t-butylamine, diisopropylamine, N,N-dimethylisopropylamine, N,N-diethylmethylamine, N,N-diisopropylethylamine, and tetrabutylammonium hydroxide, and contains a protic solvent, is used, the water repellency of the first surface 11 is easily maintained, which is preferable.

In addition, examples of the solvent of the removing agent include water and an alcohol-based solvent (for example, at least one kind selected from alcohols having 3 or less carbon atoms, such as methanol, 1-propanol, and 2-propanol (isopropanol)), where these may be used alone, or a plurality thereof may be used in combination.

In a case of using a solution containing a removing agent, the concentration thereof may be appropriately selected such that the water repellency of the second surface 12 can be selectively reduced. For example, in a case where the concentration of the entire solution containing a removing agent is set to 100% by mass, a total of the removing agent to be contained may be 0.001% by mass to 80% by mass and may be set to preferably 0.01% by mass to 50% by mass.

By the removal treatment C, the water repellency of the first surface 11 is maintained, and the water repellency of the second surface 12 is reduced. Regarding the tendency of the effect by the removal treatment C, it is presumed that the water repellency is reduced, and the water repellent film is also removed in a case where Q - R < -10° is satisfied in a case where a value (°) of the water contact angle immediately before the removal treatment C and immediately after the silylation treatment B is denoted as R, and a value (°) of the water contact angle immediately after the removal treatment C is denoted as Q.

As a result, in order to selectively reduce the water repellency of the second surface, it may be such that the first surface preferably satisfies Q - R ≥ -10°, and the second surface preferably satisfies Q - R < -10°.

One of the patterns that make it possible to reduce the water repellency by the removal treatment C includes a case where the above-described silylation rate is small (less than 5.0). It is considered that this pattern is easily removed by a removing agent since the water repellent film is formed only on a part of the surface, or the binding between the compound derived from the silylating agent and the second surface 12 is weak. In addition, this pattern can be made difficult to be removed even after undergoing the removal treatment, by carrying out the pretreatment A or changing the kind of the pretreatment A to set the silylation rate to 5.0 or more. That is, in a case where the silylation rate of the second surface is less than 5.0, it is possible to selectively reduce the water repellency of the first surface, which is preferable.

In addition, although the detailed mechanism is not revealed, one of the patterns that make it possible to reduce the water repellency other than the above-described pattern (for example, a case where the water repellency can be reduced even in a case where the silylation rate is 5.0 or more) is considered to be, for example, a pattern in a case where oxygen or the like is bonded to the Si-based surface, whereby some kind of interaction (for example, dissolution, catalytic action, or the like) is likely to occur between the surface and the treatment agent.

In the surface modification step, the surface layer of the second surface 12 may be removed by the above-described removal treatment C as long as the water repellency of the first surface 11 is not significantly impaired. For example, the second surface 12 may have oxygen elements in the surface layer thereof due to the above-described pretreatment A-2, and these oxygen elements can be removed together by removing Si to which the oxygen element has been bonded, which makes the second surface 12 be in a clean state. In addition, the removal treatment C may be carried out two or more times. In a case of removing the surface layer of the second surface 12, it is possible to suitably use hydrogen fluoride among the removing agents described above. In addition, for the intended purpose of adjusting the removal performance, a buffered hydrofluoric acid (a mixture of hydrofluoric acid and ammonium fluoride) can also be suitably used.

The surface modification step may include, as necessary, a cleaning treatment of cleaning at least a part of the second surface 12 using a cleaning agent. For example, a cleaning treatment may be carried out after the removal treatment C; however, the present invention is not limited thereto.

In addition, in a case where at least a part of the treatment A to the treatment C is carried out by a wet process, one or two or more times of cleaning treatments can be carried out between the respective treatment A to treatment C or between the individual treatments included in the treatment A to the treatment C. In a case of a plurality of cleaning treatments, the kind of cleaning agent may be changed for each cleaning treatment.

The cleaning agent may contain an aqueous cleaning solution and/or a rinsing solution.

The aqueous cleaning solution may be any solution as long as it does not remove the water repellent film 21 formed on the first surface 11 and is not particularly limited. Examples thereof include water, an alcohol, a hydrogen peroxide aqueous solution, and ozone water. These may be used alone, or two or more thereof may be used in combination.

Similar to the case of the aqueous cleaning solution, the rinsing solution may be any solution as long as it does not remove the water repellent film 21 formed on the first surface 11 and is not particularly limited. As the rinsing solution, a cleaning agent different from the aqueous cleaning solution can be used, and examples thereof include water, an organic solvent, a mixture thereof, or a cleaning agent obtained by mixing at least one kind of an acid, an alkali, a surfactant, and an oxidizing agent in water, an organic solvent, a mixture thereof.

Examples of the organic solvent used in the rinsing solution include hydrocarbons, esters, ethers, ketones, halogen element-containing solvents, sulfoxide-based solvents, alcohols, polyhydric alcohol derivatives, and nitrogen element-containing solvents. Among the above, it is preferable to use, as an organic solvent, at least one kind selected from alcohols having 3 or less carbon atoms, such as methanol, 1-propanol, and 2-propanol (isopropanol).

In the present embodiment, the method of bringing the cleaning agent into contact is not particularly limited, and examples thereof include an immersion method, a coating method such as spin coating or spray coating, and vapor contacting.

In the surface modification step, a drying treatment may be carried out as necessary.

In addition, in a case where at least a part of the treatment A to the treatment C is carried out by a wet process, one or two or more times of drying treatments can be carried out between the respective treatment A to treatment C or between the individual treatments included in the treatment A to the treatment C.

### (Processing step)

In the processing step, the second surface 12 shown in Fig. 3(b) is selectively subjected to a processing treatment after the surface modification step.

The processing treatment may include, for example, a film forming treatment of forming a film on the second surface 12 by an atomic layer deposition method and/or an etching treatment of etching the second surface 12.

In a case where the film forming treatment is carried out, the film formation according to the atomic layer deposition method is suppressed on the first surface 11; however, the film formation is carried out according to the atomic layer deposition method on the second surface 12.

In a case where the first surface 11 has favorable water repellency, there is such a tendency that the film formation by the above-described atomic layer deposition method is inhibited. Although the detailed mechanism is not clear, it is presumed that the film formation according to the atomic layer deposition method is suppressed in a case where the first surface 11 is protected by a water repellent film or the like. On the other hand, since, on the second surface 12, the water repellent film on the surface or the compound derived from the silylating agent is removed by the water repellency adjustment treatment, it is presumed that the film forming treatment can be selectively carried out on the second surface 12 as compared with the first surface 11.

As the film forming method according to the atomic layer deposition method, a publicly known ALD device can be used. For example, it is preferable to use a thin film forming method (thermal ALD method) by adsorption using a first gas phase reactant as a film forming raw material and a desired second gas phase reactant, a thin film forming method (plasma ALD method) in which the first gas phase reactant as a film forming raw material is adsorbed on the surface and then reacted with a plasma of oxygen or the like, or the like. A film formation temperature and a film formation time can be appropriately selected depending on the film thickness and the raw material.

As the first gas phase reactant, a substance containing a film forming material is used. Examples of the first gas phase reactant include an organic metal, a metal halide, and a metal oxide halide, and specific examples thereof include tantalum pentaethoxide, tetrakis(dimethylamino)titanium, pentakis(dimethylamino)tantalum, tetrakis(dimethylamino) zirconium, tetrakis(dimethylamino)hafnium, tetrakis(dimethylamino)silane, bis(hexafluoroacetylacetonato)copper, Zn(C₂H₅)₂, Zn(C₂H₅)₂, Zn(CH₃)₂, trimethylaluminum (TMA), TaCl₅, WF₆, WOCl₄, CuCl, ZrCl₄, AlCl₃, TiCl₄, SiCl₄, and HfCl₄.

The second gas phase reactant may be any substance that includes a gas capable of reacting with the first gas phase reactant or a material capable of generating an active species such as a radical. Examples thereof include H₂, H₂O, H₂O₂, O₂, O₃, HCl, HF, NH₃, H₂S, H₂Se, PH₃, AsH₃, CH₄, C₂H₄, and Si₂H₆.

The film formed by the atomic layer deposition method is not particularly limited, and examples thereof include a film containing a pure element (for example, Si, Cu, Ta, or W), a film containing an oxide (for example, SiO₂, GeO₂, HfO₂, ZrO₂, Ta₂O₅, TiO₂, Al₂O₃, ZnO, SnO₂, Sb₂O₅, B ₂O₃, In₂O₃, or WO₃), a film containing a nitride (for example, Si3N4, TiN, AlN, BN, GaN, or NbN), a film containing a carbide (for example, SiC), a film containing a sulfide (for example, CdS, ZnS, MnS, WS₂, or PbS), a film containing a selenide (for example, CdSe or ZnSe), a film containing a phosphide (GaP or InP), a film containing an arsenide (for example, GaAs or InAs), and a mixture thereof.

In a case where an etching treatment is carried out as the processing treatment, the etching of the first surface 11 is suppressed; however, the etching treatment proceeds on the second surface 12 as compared with on the first surface. Therefore, the second surface 12 can be selectively subjected to the etching treatment with respect to the first surface 11.

Although the detailed mechanism is not clear, it is presumed that the etching of the first surface 11 is suppressed as compared with the etching of the second surface 12 since the remaining water repellent film 21 plays a role such as a shielding material for the etching agent.

The etching treatment is not particularly limited as long as it is a method that is capable of etching the second surface 12, and a publicly known dry etching method or wet etching method can be selected.

In addition, it is preferable that various etching treatments are carried out using an etching agent. In a case of a gas, examples thereof include an inter-halogen gas such as a Cl₂ gas, an F₂ gas, a ClF₃ gas, or an IF₇ gas, an NH₃ gas, and a gas including a mixed gas of these various gases. In addition, in a case of a liquid, examples thereof include a liquid obtained by diluting at least one of HF, NH₄F, NH₄HF₂, H₃PO₄, or H₂SO₄ with a solvent. In addition, as the etching agent, such as one that is heated or is made into a plasma state or a radical state may be used.

In addition, in a case where a value of a water contact angle on the first surface is denoted as S1 and a value of a water contact angle on the second surface is denoted as S2 immediately before the processing step after the surface modification step, it is preferable that a value calculated by "(S1 - S2)/S2" is 1.0 or more. In a case where it is set in the above-described range, the selectivity during the processing step, particularly the selectivity during the film formation by ALD is likely to be favorable, which is suitable. In addition, (S1 - S2)/S2 may be more preferably 1.5 or more.

In addition, the water contact angle S1 of the first surface 11 is preferably 65° or more. In a case where it is set in the above-described range, the selective processability is easily improved. In particular, it is suitable during the etching treatment. The water contact angle S1 may be more preferably set to 70° or more and still more preferably set to 75° or more. In addition, the water contact angle S2 of the second surface 12 is not particularly limited as long as (S1 - S2)/S2 ≥ 1.0 is satisfied; however, in a case where it is set to, for example, 60° or less, the selective processability is easily improved, which is preferable. It may be more preferably set to 56° or less.

After the above-described processing step, in a case where the water repellent film remaining on the first surface is unnecessary, the water repellent film may be removed. The removal method is not particularly limited as long as it is a method that is capable of removing a publicly known silylated group.

Examples thereof include light (ultraviolet rays) irradiation, heat treatment, ozone exposure, plasma irradiation, and corona discharge. In addition, the removal by a wet process is also possible, and examples thereof include contacting with an aqueous ammonium hydroxide solution, an aqueous tetramethylammonium solution, an aqueous hydrochloric acid solution, an aqueous sulfuric acid solution, or the like.

The substrate manufacturing method according to the present embodiment includes a step of obtaining a substrate that has been substrate processing method to each step in the above-described substrate processing method. A desired semiconductor wafer or a desired semiconductor device can be obtained by the substrate manufacturing method.

### <Silylating agent>

A silylating agent that is used in the silylation treatment in the above-described substrate processing method, and a silylation composition containing the silylating agent will be described.

As the silylating agent, a publicly known silylating agent can be used.

Examples of the silylating agent include a silicon compound represented by General Formula [1]. These may be used alone, or two or more thereof may be used in combination. In a case of using two or more kinds thereof in combination, it may be described as a "silylation composition". In addition, in the silicon compound contained in the silylation composition, the number of carbon atoms of R¹ in General Formula [1] may be the same as or different.

R¹ₐSi(H)_{b}X_{4-a-b} [1]

In General Formula [1], R¹'s each independently represent an organic group including a hydrocarbon group having 1 to 18 carbon atoms, in which a part or all of hydrogen elements may be substituted with a fluorine element, X's each independently represent a monovalent organic group in which an element bonded to a Si element is nitrogen, oxygen, carbon, or halogen, a represents an integer of 1 to 3, b represents an integer of 0 to 2, and a sum of a and b is 1 to 3.

R¹ in General Formula [1] may contain not only a hydrogen element, a carbon element, a nitrogen element, an oxygen element, and a fluorine element but also a silicon element, a sulfur element, a halogen element (other than fluorine).

In addition, R¹ in General Formula [1] may contain an unsaturated bond, an aromatic ring, or a cyclic structure.

Examples of R¹'s in General Formula [1] each independently include at least one group selected from CₑH_{2e + 1} (e = 1 to 18) and C_{f}F_{2f + 1}CH₂CH₂ (f = 1 to 8). Among these, a silicon compound having a trialkylsilyl group is particularly preferable.

It is noted that in a case where R¹ in General Formula [1] described above includes a silicon element, General Formula [1] may have a structure of General Formula [1-1] shown below.

R¹ₘX₃₋ₘ₋ₙ(H)ₙSi-(CH₂)ₚ-Si(H)ₙX₃₋ₘ₋ₙR¹ₘ [1-1]

It is noted that in General Formula [1-1], R¹'s and X are the same as in General Formula [1] (however, a silicon element is not included in R¹'s), m is an integer of 1 or 2, n is an integer of 0 or 1, a sum of m and n is 1 or 2, p is an integer of 1 to 18, and a methylene chain represented by -(CH₂)ₚ- may be substituted with halogen.

In X in General Formula [1], the monovalent organic group in which the element bonded to the Si element is nitrogen, oxygen, or carbon may include not only hydrogen, carbon, nitrogen, and oxygen elements but also a silicon element, a sulfur element, a halogen element.

Examples of the above-described monovalent organic group in which the element bonded to the Si element is nitrogen include an isocyanate group, an amino group, a dialkylamino group, an isothiocyanate group, an azido group, an acetamide group, - NHC(=O)CF₃, -N(CH₃)C(=O)CH₃, -N(CH₃)C(=O)CF₃, -N=C(CH₃)OSi(CH₃)₃, - N=C(CF₃)OSi(CH₃)₃, -NHC(=O)-OSi(CH₃)₃, -NHC(=O)-NH-Si(CH₃)₃, an imidazole ring, a triazole ring, a tetrazole ring, an oxazolidinone ring, a morpholine ring, -NH-C(=O)-Si(CH₃)₃, - N(S(=O)₂R⁴)₂ (here, R⁴'s each independently represent a group selected from the group consisting of a monovalent hydrocarbon group having 1 to 8 carbon atoms, in which a part or all of hydrogen elements may be substituted with a fluorine element, and a fluorine element), a substituent having a structure of General Formula [1-2] 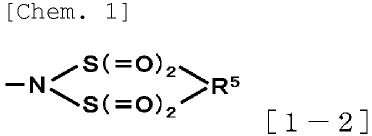 (In General Formula [1-2], R⁵'s each independently is a divalent hydrocarbon group having 1 to 8 carbon atoms in which part or all of the hydrogen elements may be substituted with fluorine elements), -N=C(NR⁶₂)₂, -N=C(NR⁶₂)R⁶ (here, R⁶'s each independently is selected from a hydrogen group, a -C≡N group, a -NO₂ group, and a hydrocarbon group in which part or all of hydrogen elements may be substituted with fluorine elements, and the hydrocarbon group may have an oxygen atom and/or a nitrogen atom), -N(R^{a1})(R^{a2}) (Here, R^{a1} represents a hydrogen atom, or a saturated or unsaturated alkyl group, and R^{a2} represents a saturated or unsaturated alkyl group, a saturated or unsaturated cycloalkyl group, or a saturated or unsaturated heterocycloalkyl group. R^{a1} and R^{a2} may be bonded to each other to form a saturated or unsaturated heterocycloalkyl group having a nitrogen atom) , -N(R ^{a3})-Si(R^{a4})(R^{a5})(R^{a6}) (here, R^{a3} represents a hydrogen atom, a hydrocarbon group having 1 to 4 carbon atoms, a trimethylsilyl group, or a dimethylsilyl group, R^{a4}, R^{a5}, and R^{a6} each independently represent a hydrogen atom or an organic group, the total number of carbon atoms contained in R^{a4}, R^{a5}, and R^{a6} is equal to or more than 1), -N(R^{a7})-C(=O)R^{a8} (here, R^{a7} represents a hydrogen atom, a methyl group, a trimethylsilyl group, or a dimethylsilyl group, and R^{a8} represents a hydrogen atom, a saturated or unsaturated alkyl group, or a fluorine-containing alkyl group, or a trialkylsilylamino group), and the like.

Examples of the silylating agent, in which X in General Formula [1] is a monovalent organic group having nitrogen as an element bonded to the Si element, include amino silanes such as CH₃Si(NH₂)₃, C₂H₅Si(NH₂)₃, C₃H₇Si(NH₂)₃, C₄H₉Si(NH₂)₃, C₅H₁₁Si(NH₂)₃, C₆H₁₃Si(NH₂)₃, C₇H₁₅Si(NH₂)₃, C₈H₁₇Si(NH₂)₃, C₉H₁₉Si(NH₂)₃, C₁₀H₂₁Si(NH₂)₃, C₁₁H₂₃Si(NH₂)₃, C₁₂H₂₅Si(NH₂)₃, C₁₃H₂₇Si(NH₂)₃, C₁₄H₂₉Si(NH₂)₃, C₁₅H₃₁Si(NH₂)₃, C₁₆H₃₃Si(NH₂)₃, C₁₇H₃₅Si(NH₂)₃, C₁₈H₃₇Si(NH₂)₃, (CH₃)₂Si(NH₂)₂, C₂H₅Si(CH₃)(NH₂)₂, (C₂H₅)₂Si(NH₂)₂, C₃H₇Si(CH₃)(NH₂)₂, (C₃H₇)₂Si(NH₂)₂, C₄H₉Si(CH₃)(NH₂)₂, (C₄H₉)₂Si(NH₂)₂, C₅H₁₁Si(CH₃)(NH₂)₂, C₆H₁₃Si(CH₃)(NH₂)₂, C₇H₁₅Si(CH₃)(NH₂)₂, C₈H₁₇Si(CH₃)(NH₂)₂, C₉H₁₉Si(CH₃)(NH₂)₂, C₁₀H₂₁Si(CH₃)(NH₂)₂, C₁₁H₂₃Si(CH₃)(NH₂)₂, C₁₂H₂₅Si(CH₃)(NH₂)₂, C₁₃H₂₇Si(CH₃)(NH₂)₂, C₁₄H₂₉Si(CH₃)(NH₂)₂, C₁₅H₃₁Si(CH₃)(NH₂)₂, C₁₆H₃₃Si(CH₃)(NH₂)₂, C₁₇H₃₅Si(CH₃)(NH₂)₂, C₁₈H₃₇Si(CH₃)(NH₂)₂, (CH₃)₃SiNH₂, C₂H₅Si(CH₃)₂NH₂, (C₂H₅)₂Si(CH₃)NH₂, (C₂H₅)₃SiNH₂, C₃H₇Si(CH₃)₂NH₂, (C₃H₇)₂Si(CH₃)NH₂, (C₃H₇)₃SiNH₂, C₄H₉Si(CH₃)₂NH₂, (C₄H₉)₃SiNH₂, C₅H₁₁Si(CH₃)₂NH₂, C₆H₁₃Si(CH₃)₂NH₂, C₇H₁₅Si(CH₃)₂NH₂, C₈H₁₇Si(CH₃)₂NH₂, C₉H₁₉Si(CH₃)₂NH₂, C₁₀H₂₁Si(CH₃)₂NH₂, C₁₁H₂₃Si(CH₃)₂NH₂, C₁₂H₂₅Si(CH₃)₂NH₂, C₁₃H₂₇Si(CH₃)₂NH₂, C₁₄H₂₉Si(CH₃)₂NH₂, C₁₅H₃₁Si(CH₃)₂NH₂, C₁₆H₃₃Si(CH₃)₂NH₂, C₁₇H₃₅Si(CH₃)₂NH₂, C₁₈H₃₇Si(CH₃)₂NH₂, (CH₃)₂Si(H)NH₂, CH₃Si(H)₂NH₂, (C₂H₅)₂Si(H)NH₂, C₂H₅Si(H)₂NH₂, C₂H₅Si(CH₃)(H)NH₂, (C₃H₇)₂Si(H)NH₂, C₃H₇Si(H)₂NH₂, CF₃CH₂CH₂Si(NH₂)₃, C₂F₅CH₂CH₂Si(NH₂)₃, C₃F₇CH₂CH₂Si(NH₂)₃, C₄F₉CH₂CH₂Si(NH₂)₃, C₅F₁₁CH₂CH₂Si(NH₂)₃, C₆F₁₃CH₂CH₂Si(NH₂)₃, C₇F₁₅CH₂CH₂Si(NH₂)₃, C₈F₁₇CH₂CH₂Si(NH₂)₃, CF₃CH₂CH₂Si(CH₃)(NH₂)₂, C₂F₅CH₂CH₂Si(CH₃)(NH₂)₂, C₃F₇CH₂CH₂Si(CH₃)(NH₂)₂, C₄F₉CH₂CH₂Si(CH₃)(NH₂)₂, C₅F₁₁CH₂CH₂Si(CH₃)(NH₂)₂, C₆F₁₃CH₂CH₂Si(CH₃)(NH₂)₂, C₇F₁₅CH₂CH₂Si(CH₃)(NH₂)₂, C₈F₁₇CH₂CH₂Si(CH₃)(NH₂)₂, CF₃CH₂CH₂Si(CH₃)₂NH₂, C₂F₅CH₂CH₂Si(CH₃)₂NH₂, C₃F₇CH₂CH₂Si(CH₃)₂NH₂, C₄F₉CH₂CH₂Si(CH₃)₂NH₂, C₅F₁₁CH₂CH₂Si(CH₃)₂NH₂, C₆F₁₃CH₂CH₂Si(CH₃)₂NH₂, C₇F₁₅CH₂CH₂Si(CH₃)₂NH₂, C₈F₁₇CH₂CH₂Si(CH₃)₂NH₂, CF₃CH₂CH₂Si(CH₃)(H)NH₂, aminodimethylvinylsilane, aminodimethylphenylethylsilane, aminodimethylphenylsilane, aminomethyldiphenylsilane, and aminodimethyl-t-butylsilane.

In addition, examples thereof include those obtained by replacing the amino group (-NH₂ group) in the amino silane with the following groups:
-N=C=O, a dialkylamino group (-N(CH₃)₂, -N(C₂H₅)₂, and the like), a t-butylamino group, an allylamino group, -N=C=S, -N₃, - NHC(=O)CH₃, -NHC(=O)CF₃, -N(CH₃)C(=O)CH₃, -N(CH₃)C(=O)CF₃, - N=C(CH₃)OSi(CH₃)₃, -N=C(CF₃)OSi(CH₃)₃, -NHC(=O)-OSi(CH₃)₃, - NHC(=O)-NH-Si(CH₃)₃ (for example, N,N'-bis(trimethylsilyl)urea and the like), an imidazole ring (for example, N-trimethylsilylimidazole and the like), a triazole ring (for example, N-trimethylsilyltriazole), a tetrazole ring, an oxazolidinone ring, a morpholine ring, -NH-C(=O)-Si(CH₃)₃, - N(S(=O)₂R⁴)₂ (here, R⁴'s each independently represent a group selected from the group consisting of a monovalent hydrocarbon group having 1 to 8 carbon atoms, in which a part or all of hydrogen elements may be substituted with a fluorine element, and a fluorine element; for example, N-(trimethylsilyl)bis(trifluoromethanesulfonyl)imide and the like), a substituent having a structure of General Formula [1-2] 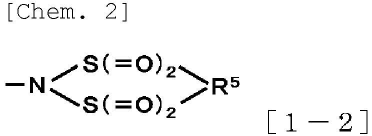
(In General Formula [1-2], R⁵'s each independently represent a divalent hydrocarbon group having 1 to 8 carbon atoms, in which a part of or all of hydrogen elements may be substituted with a fluorine element. For example, N-(trimethylsilyl) N,N-difluoromethane-1,3-bis (sulfonyl) imide and the like), - N=C(NR⁶₂)₂, -N=C(NR⁶₂)R⁶ (Here, R⁶ each independently selected from a hydrogen group, a -C≡N group, a -NO₂ group, and a hydrocarbon group in which part or all of hydrogen elements may be substituted with fluorine elements, and the hydrocarbon group may have an oxygen atom and/or a nitrogen atom. For example, 2-trimethylsilyl-1,1,3,3-tetramethylguanidine, and the like), - N(R^{a1})R^{a2} (here, R^{a1} represents a hydrogen atom or a saturated or unsaturated alkyl group, R^{a2} represents a saturated or unsaturated alkyl group, a saturated or unsaturated cycloalkyl group, or a saturated or unsaturated heterocycloalkyl group. R^{a1} and R^{a2} may be bonded to form a saturated or unsaturated heterocycloalkyl group having a nitrogen atom), -N(R^{a3})-Si(R^{a4})(R^{a5})(R^{a6}) (Here, R^{a3} represents a hydrogen atom, a hydrocarbon group having 1 to 4 carbon atoms, a trimethylsilyl group, or a dimethylsilyl group, and R^{a4}, R^{a5}, and R^{a6} each independently represent a hydrogen atom or an organic group, and the total number of carbon atoms contained in R^{a4}, R^{a5}, and R^{a6} is one or more. For example, hexamethyldisilazane, N-methylhexamethyldisilazane, 1,1,3,3-tetramethyldisilazane, 1,3-dimethyldisilazane, 1,3-di-N-octyltetramethyldisilazane, 1,3-divinyltetramethyldisilazane, heptamethyldisilazane, N-allyl-N,N-bis(trimethylsilyl)amine, 1,3-diphenyltetramethyldisilazane, 1,1,3,3-tetraphenyl-1,3-dimethyldisilazane, nonamethyltrisilazane, pentamethylethyldisilazane, pentamethylvinyldisilazane, pentamethylpropyldisilazane, pentamethylethyldisilazane, pentamethyl-t-butyldisilazane, pentamethylphenyldisilazane, trimethyltriethyldisilazane, and the like), -N(R^{a7})-C(=O)R^{a8} (Here, R^{a7} represents a hydrogen atom, a methyl group, a trimethylsilyl group, or a dimethylsilyl group, and R^{a8} represents a hydrogen atom, a saturated or unsaturated alkyl group, a fluorine-containing alkyl group, or a trialkylsilylamino group. For example, N-trimethylsilylacetamide, N-trimethylsilyltrifluoroacetamide, N-methyl-N-trimethylsilylacetamide, N-methyl-N-trimethylsilyltrifluoroacetamide, bis(trimethylsilyl) acetamide, bis(trimethylsilyl) trifluoroacetamide, and the like.).

Examples of the silylating agent, in which X in General Formula [1] is a monovalent organic group having oxygen as an element bonded to the Si element, include those obtained by replacing the amino group (-NH₂ group) in the above-described amino silane with the following groups:
-O-C(=A)R^{a9} (Here, A represents O, CHR^{a10}, CHOR^{a10}, CR^{a10}R^{a10}, or NR^{a11}, where R^{a9} and R^{a10} each independently represent a hydrogen atom, a saturated or unsaturated alkyl group, a saturated or unsaturated cycloalkyl group, a fluorine-containing alkyl group, a chlorine-containing alkyl group, a trialkylsilyl group, a trialkylsiloxy group, an alkoxy group, a phenyl group, a phenyl ethyl group, or an acetyl group, and R^{a11} represents a hydrogen atom, an alkyl group, or a trialkylsilyl group. For example, trimethylsilyl acetate, dimethylsilyl acetate, monomethylsilyl acetate, trimethylsilyl trifluoroacetate, dimethylsilyl trifluoroacetate, monomethylsilyl trifluoroacetate, trimethylsilyl trichloroacetate, trimethylsilyl propionate, trimethylsilyl butyrate, and the like), -O-C(R^{a12})=N(R^{a13}) (here, R^{a12} represents a hydrogen atom, a saturated or unsaturated alkyl group, a fluorine-containing alkyl group, or a trialkylsilylamino group, and R^{a13} represents a hydrogen atom, an alkyl group, and a trialkylsilyl group), -O-C(R^{a14})=CH-C(=O) R^{a15} (Here, R^{a14} and R^{a15} each independent represents a hydrogen atom or an organic group. For example, trimethylsilyloxy-3-pentene-2-on, 2-trimethylsiloxypenta-2-en-4-on, and the like), -OR^{a16} (here, R^{a16} represents a saturated or unsaturated alkyl group, a saturated or unsaturated cycloalkyl group, or a fluorine-containing alkyl group. Examples of the silylating agent having the -OR^{a16} include alkyl methoxysilanes such as CH₃Si(OCH₃)₃, C₂H₅Si(OCH₃)₃, C₃H₇Si(OCH₃)₃, C₄H₉Si(OCH₃)₃, C₅H₁₁Si(OCH₃)₃, C₆H₁₃Si(OCH₃)₃, C₇H₁₅Si(OCH₃)₃, C₈H₁₇Si(OCH₃)₃, C₉H₁₉Si(OCH₃)₃, C₁₀H₂₁Si(OCH₃)₃, C₁₁H₂₃Si(OCH₃)₃, C₁₂H₂₅Si(OCH₃)₃, C₁₃H₂₇Si(OCH₃)₃, C₁₄H₂₉Si(OCH₃)₃, C₁₅H₃₁Si(OCH₃)₃, C₁₆H₃₃Si(OCH₃)₃, C₁₇H₃₅Si(OCH₃)₃, C₁₈H₃₇Si(OCH₃)₃, (CH₃)₂Si(OCH₃)₂, C₂H₅Si(CH₃)(OCH₃)₂, (C₂H₅)₂Si(OCH₃)₂, C₃H₇Si(CH₃)(OCH₃)₂, (C₃H₇)₂Si(OCH₃)₂, C₄H₉Si(CH₃)(OCH₃)₂, (C₄H₉)₂Si(OCH₃)₂, C₅H₁₁Si(CH₃)(OCH₃)₂, C₆H₁₃Si(CH₃)(OCH₃)₂, C₇H₁₅Si(CH₃)(OCH₃)₂, C₈H₁₇Si(CH₃)(OCH₃)₂, C₉H₁₉Si(CH₃)(OCH₃)₂, C₁₀H₂₁Si(CH₃)(OCH₃)₂, C₁₁H₂₃Si(CH₃)(OCH₃)₂, C₁₂H₂₅Si(CH₃)(OCH₃)₂, C₁₃H₂₇Si(CH₃)(OCH₃)₂, C₁₄H₂₉Si(CH₃)(OCH₃)₂, C₁₅H₃₁Si(CH₃)(OCH₃)₂, C₁₆H₃₃Si(CH₃)(OCH₃)₂, C₁₇H₃₅Si(CH₃)(OCH₃)₂, C₁₈H₃₇Si(CH₃)(OCH₃)₂, (CH₃)₃SiOCH₃, C₂H₅Si(CH₃)₂OCH₃, (C₂H₅)₂Si(CH₃)OCH₃, (C₂H₅)₃SiOCH₃, C₃H₇Si(CH₃)₂OCH₃, (C₃H₇)₂Si(CH₃)OCH₃, (C₃H₇)₃SiOCH₃, C₄H₉Si(CH₃)₂OCH₃, (C₄H₉)₃SiOCH₃, C₅H₁₁Si(CH₃)₂OCH₃, C₆H₁₃Si(CH₃)₂OCH₃, C₇H₁₅Si(CH₃)₂OCH₃, C₈H₁₇Si(CH₃)₂OCH₃, C₉H₁₉Si(CH₃)₂OCH₃, C₁₀H₂₁Si(CH₃)₂OCH₃, C₁₁H₂₃Si(CH₃)₂OCH₃, C₁₂H₂₅Si(CH₃)₂OCH₃, C₁₃H₂₇Si(CH₃)₂OCH₃, C₁₄H₂₉Si(CH₃)₂OCH₃, C₁₅H₃₁Si(CH₃)₂OCH₃, C₁₆H₃₃Si(CH₃)₂OCH₃, C₁₇H₃₅Si(CH₃)₂OCH₃, C₁₈H₃₇Si(CH₃)₂OCH₃, (CH₃)₂Si(H)OCH₃, CH₃Si(H)₂OCH₃, (C₂H₅)₂Si(H)OCH₃, C₂H₅Si(H)₂OCH₃, C₂H₅Si(CH₃)(H)OCH₃, and (C₃H₇)₂Si(H)OCH₃; fluoroalkyl methoxysilanes such as CF₃CH₂CH₂Si(OCH₃)_{3,} C₂F₅CH₂CH₂Si(OCH₃)₃, C₃F₇CH₂CH₂Si(OCH₃)₃, C₄F₉CH₂CH₂Si(OCH₃)₃, C₅F₁₁CH₂CH₂Si(OCH₃)₃, C₆F₁₃CH₂CH₂Si(OCH₃)₃, C₇F₁₅CH₂CH₂Si(OCH₃)₃, C₈F₁₇CH₂CH₂Si(OCH₃)₃, CF₃CH₂CH₂Si(CH₃)(OCH₃)₂, C₂F₅CH₂CH₂Si(CH₃)(OCH₃)₂, C₃F₇CH₂CH₂Si(CH₃)(OCH₃)₂, C₄F₉CH₂CH₂Si(CH₃)(OCH₃)₂, C₅F₁₁CH₂CH₂Si(CH₃)(OCH₃)₂, C₆F₁₃CH₂CH₂Si(CH₃)(OCH₃)₂, C₇F₁₅CH₂CH₂Si(CH₃)(OCH₃)₂, CeF₁₇CH₂CH₂Si(CH₃)(OCH₃)₂, CF₃CH₂CH₂Si(CH₃)₂OCH₃, C₂F₅CH₂CH₂Si(CH₃)₂OCH₃, C₃F₇CH₂CH₂Si(CH₃)₂OCH₃, C₄F₉CH₂CH₂Si(CH₃)₂OCH₃, C₅F₁₁CH₂CH₂Si(CH₃)₂OCH₃, C₆F₁₃CH₂CH₂Si(CH₃)₂OCH₃, C₇F₁₅CH₂CH₂Si(CH₃)₂OCH₃, C₈F₁₇CH₂CH₂Si(CH₃)₂OCH₃, and CF₃CH₂CH₂Si(CH₃)(H)OCH₃; or a compound or the like obtained by replacing the methyl group moiety of the methoxy group of the methoxysilane with a monovalent hydrocarbon group having 2 to 18 carbon atoms in which a part or all of hydrogen elements may be substituted with a fluorine element), -O-S(=O)₂-R^{a17} (here, R^{a17} represents an alkyl group having 1 to 6 carbon atoms, a perfluoroalkyl group, a phenyl group, a tolyl group, or a -O-Si(CH₃)₃ group. For example, trimethylsilylsulfonate, trimethylsilylbenzenesulfonate, trimethylsilyltoluenesulfonate, trimethylsilyltrifluoromethanesulfonate, trimethylsilylperfluorobutanesulfonate, bistrimethylsilylsulfate, and the like, or -O-P(-O-Si(CH₃)₃)₂ (for example, tristrimethylsilylphosphite).

In addition, examples of the silylating agent, in which X in General Formula [1] is a monovalent organic group having oxygen as an element bonded to the Si element, also include siloxane compounds such as hexamethyldisiloxane, 1,3-diphenyl-1,3-dimethyldisiloxane, 1,1,3,3-tetramethyldisiloxane, 1,1,1-triethyl-3,3-dimethyldisiloxane, 1,1,3,3-tetra-n-octyldimethyldisiloxane, bis(nonafluorohexyl)tetramethyldisiloxane, 1,3-bis(trifluoropropyl)tetramethyldisiloxane, 1,3-di-n-butyltetramethyldisiloxane, 1,3-di-n-octyltetramethyldisiloxane, 1,3-diethyltetramethyldisiloxane, 1,3-diphenyltetramethyldisiloxane, hexa-n-butyl disiloxane, hexaethyldisiloxane, hexavinyl disiloxane, 1,1,3,3-tetraisopropyldisiloxane, vinylpentamethyldisiloxane, 1,3-bis(3-chloroisobutyl)tetramethyldisiloxane, hexaphenyldisiloxane, 1,1,1-triethyl-3,3,3-trimethyldisiloxane, 1,3-bis(chloromethyl)tetramethyldisiloxane, 1,1,3,3-tetraphenyldimethyldisiloxane, pentamethyldisiloxane, 1,3-bis(3-chloropropyl)tetramethyldisiloxane, 1,3-dichloro-1,3-diphenyl-1,3-dimethyldisiloxane, n-butyl-1,1,3,3-tetramethyldisiloxane, 1,1,3,3-tetraphenyldisiloxane,1,3-di-t-butyl disiloxane, vinyl-1,1,3,3,-tetramethyldisiloxane, 1,1,1-trimethyl-3,3,3-triphenyldisiloxane, 3,3-diphenyltetramethyltrisiloxane, 3-phenylheptamethyltrisiloxane, hexamethylcyclotrisiloxane, n-propylheptamethyltrisiloxane, 3-ethylheptamethyltrisiloxane, 3-(3,3,3-trifluoropropyl)heptamethyltrisiloxane, 1,1,3,5,5-pentaphenyl-1,3,5-trimethyltrisiloxane, octamethyltrisiloxane, 1,1,5,5-tetraphenyl-1,3,3,5-tetramethyltrisiloxane, hexaphenylcyclotrisiloxane, 1,1,1,5,5,5-hexamethyltrisiloxane, 3-phenyl-1,1,3,5,5-pentamethyltrisiloxane, 1,3,5-trivinyl-1,1,3,5,5-pentamethyltrisiloxane, 1,3,5-trivinyl-1,3,5-trimethylcyclotrisiloxane, 3-octylheptamethyltrisiloxane, 1,3,5-triphenyltrimethylcyclotrisiloxane, 1,1,1,3,3,5,5-heptamethyltrisiloxane, 1,1,3,3,5,5-hexamethyltrisiloxane, 1,1,1,5,5,5-hexaethyl-3-methyltrisiloxane,flufrilloxytrisiloxane, tetrakis(dimethylsiloxy)silane, 1,1,3,3,5,5,7,7-octamethyltetrasiloxane, diphenylsiloxane-dimethylsiloxane copolymer, 1,3-diphenyl-1,3-dimethyldisiloxane, octamethylcyclotetrasiloxane, 1,3-bis(trimethylsiloxy)-1,3-dimethyldisiloxane, tetra-n-propyltetramethylcyclotetrasiloxane, octaethylcyclotetrasiloxane, decamethyltetrasiloxane, dodecamethylcyclohexasiloxane, dodecamethylpentasiloxane, tetradecamethylhexasiloxane, hexaphenylcyclotrisiloxane, polydimethylsiloxane, polyoctadecylmethylsiloxane, decamethylcyclopentasiloxane, poly(3,3,3-trifluoropropylmethylsiloxane), a polydimethylsiloxane terminated with trimethylsiloxy, and 1,1,3,3,5,5,7,7,9,9-decamethylpentasiloxane.

Examples of the silylating agent, in which X in General Formula [1] is a monovalent organic group having carbon as an element bonded to the Si element, include those obtained by replacing the amino group (-NH₂ group) in the above-described amino silane with -C(S(=O)₂R⁷)₃ (here, R⁷'s each independently represent a group selected from the group consisting of a monovalent hydrocarbon group having 1 to 8 carbon atoms, in which a part or all of hydrogen elements may be substituted with a fluorine element, and a fluorine element; for example, (trimethylsilyl)tris(trifluoromethanesulfonyl)methide and the like).

In addition, examples of the silylating agent, in which X in General Formula [1] is a monovalent organic group having a halogen as an element bonded to the Si element, include those obtained by replacing the amino group (-NH₂ group) in the above-described amino silane with a chloro group, a bromo group, or an iodo group (for example, chlorotrimethylsilane, bromotrimethylsilane, and the like).

The above-described silylating agent may include a cyclic silazane compound.

Examples of the above-described cyclic silazane compound include cyclic disilazane compounds such as 2,2,5,5-tetramethyl-2,5-disila-1-azacyclopentane and 2,2,6,6-tetramethyl-2,6-disila-1-azacyclohexane; cyclic trisilazane compounds such as 2,2,4,4,6,6-hexamethylcyclotrisilazane and 2,4,6-trimethyl-2,4,6-trivinylcyclotrisilazane; and cyclic tetrasilazane compounds such as 2,2,4,4,6,6,8,8-octamethylcyclotetrasilazane.

In a case where the above-described silylating agent is supplied in a form of a gas such as a gas, the silylating agent may be supplied as a mixed gas that is used together with an inert gas at the same time. Examples of the inert gas include N₂, Ar, He, Ne, and CF₄. N₂, Ar, or He is preferable.

The silylation composition refers to a composition in which two or more kinds of the above-described silylating agents are combined, or a composition containing a compound other than the above-described mixed gas or the silylating agent. The above-described silylation composition may contain in addition to the above-described silylating agent, a catalytic compound that promotes the silylation reaction by the silylating agent. As the catalytic compound, it is preferable to use one or more kinds selected from the group consisting of a compound A described later, an acid imidized product, a nitrogen-containing compound, a nitrogen-containing heterocyclic compound not containing a silicon atom, and a silylated heterocyclic compound.

Here, the catalytic compound is a compound that can promote the above-described reaction between each of the surfaces and the silylating agent or can enhance the water-repellency performance of the water repellent film to be formed, and the catalytic compound itself or a modified product thereof may form a part of the water repellent film.

The concentration of the catalytic compound may be, for example, 0.005% by mass or more and 20% by mass or less, or 0.05% by mass or more and 15% by mass or less with respect to 100% by mass of the above-described silylation composition.

Specific examples of the above-described compound A include trimethylsilyl trifluoroacetate, trimethylsilyl trifluoromethanesulfonate, dimethylsilyl trifluoroacetate, dimethylsilyl trifluoromethanesulfonate, butyldimethylsilyl trifluoroacetate, butyldimethylsilyl trifluoromethanesulfonate, hexyldimethylsilyl trifluoroacetate, hexyldimethylsilyl trifluoromethanesulfonate, octyldimethylsilyl trifluoroacetate, octyldimethylsilyl trifluoromethanesulfonate, decyldimethylsilyl trifluoroacetate, and decyldimethylsilyl trifluoromethanesulfonate, and one or more kinds selected from these compounds can be included. These may be used alone, or two or more thereof may be used in combination.

It is noted that although the above-described compound A may correspond to the above-described silylating agent, the compound A is intended to mean that, in a case of being used as a catalytic compound, the compound A to be used and the above-described silylating agent are used in combination.

The above-described compound A may be a compound obtained by reacting a silicon compound represented by General Formula [2] with one or more acetic acids or sulfonic acids selected from the group consisting of trifluoroacetic acid, trifluoroacetic acid anhydride, trifluoromethanesulfonic acid, and trifluoromethanesulfonic acid anhydride.

A surplus silicon compound represented by General Formula [2], which remains without being consumed in this reaction, can be used as the above-described silylating agent together with the compound A obtained in the reaction. The silicon compound represented by General Formula [2] may be reacted with the above-described acetic acid or sulfonic acid at a molar ratio of, for example, 0.2 to 100,000 times by mole, preferably 0.5 to 50000 times by mole and more preferably 1 to 10,000 times by mole.

R²_{c}(H)_{d}Si-X [2]

In General Formula [2], examples of R²_{c}(H)_{d}Si- include (CH₃)₃Si-, (CH₃)₂(H)Si-, (C₄H₉)(CH₃)₂Si-, (C₆H₁₃)(CH₃)₂Si-, (C₈H₁₇)(CH₃)₂Si-, and (C₁₀H₂₁)(CH₃)₂Si-. In addition, X is the same as in General Formula [1] described above.

In addition, the above-described compound A may be at least one kind selected from the group consisting of a sulfonic acid represented by General Formula [3], an anhydride of the sulfonic acid, a salt of the sulfonic acid, and a sulfonic acid derivative represented by General Formula [4].

R⁸-S(=O)₂OH [3]

[In General Formula [3], R⁸ represents a group selected from the group consisting of a monovalent hydrocarbon group having 1 to 8 carbon atoms, in which a part or all of hydrogen elements may be substituted with a fluorine element, and a hydroxyl group.]

   R^{8'}-S(=O)₂O-Si(H)₃₋ᵣ(R⁹)ᵣ [4]
[In General Formula [4], R^{8'} represents a monovalent hydrocarbon group having 1 to 8 carbon atoms, in which a part or all of hydrogen elements may be substituted with a fluorine element, R⁹'s each independently represent at least one group selected from monovalent hydrocarbon groups having 1 to 18 carbon atoms, in which a part or all of hydrogen elements may be substituted with a fluorine element, and r represents an integer of 1 to 3.]

In addition, the above-described compound A may be at least one kind selected from the group consisting of a sulfonic acid ester represented by General Formula [5], a sulfonimide represented by each of General Formulae [6] and [7], sulfonimide derivatives represented by General Formulae [8] and [9], a sulfone methide represented by General Formula [10], and a sulfone methide derivative represented by General Formula [11].

R¹⁰-S(=O)₂OR¹¹ [5]

[In General Formula [5], R¹⁰ represents a group selected from the group consisting of a monovalent hydrocarbon group having 1 to 8 carbon atoms, in which a part or all of hydrogen elements may be substituted with a fluorine element, and a fluorine element, and R¹¹ represents a monovalent alkyl group having 1 to 18 carbon atoms.]

   (R¹²-S(=O)₂)₂NH [6]
[In General Formula [6], R¹²'s each independently represent a group selected from the group consisting of a monovalent hydrocarbon group having 1 to 8 carbon atoms, in which a part or all of hydrogen elements may be substituted with a fluorine element, and a fluorine element.] 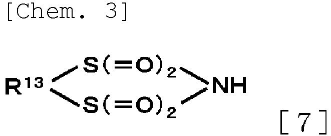
[In General Formula [7], R¹³ represents a divalent hydrocarbon group having 1 to 8 carbon atoms, in which a part or all of hydrogen elements may be substituted with a fluorine element.]

   ((R¹⁴-S(=O)₂)₂N)ₛSi(H)ₜ(R¹⁵)₄₋ₛ₋ₜ [8]
[In General Formula [8], R¹⁴'s each independently represent a group selected from the group consisting of a monovalent hydrocarbon group having 1 to 8 carbon atoms, in which a part or all of hydrogen elements may be substituted with a fluorine element, and a fluorine element, R¹⁵'s each independently represent a monovalent hydrocarbon group having 1 to 18 carbon atoms, in which a part or all of hydrogen elements may be substituted with a fluorine element, s represents an integer of 1 to 3, t represents an integer of 0 to 2, and a sum of s and t is 3 or less.] 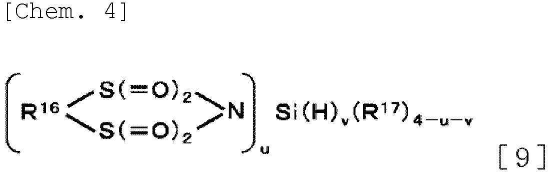
[In General Formula [9], R¹⁶'s each independently represent a divalent hydrocarbon group having 1 to 8 carbon atoms, in which a part or all of hydrogen elements may be substituted with a fluorine element, R¹⁷'s each independently represent a monovalent hydrocarbon group having 1 to 18 carbon atoms, in which a part or all of hydrogen elements may be substituted with a fluorine element, u represents an integer of 1 to 3, v represents an integer of 0 to 2, and a sum of u and v is 3 or less.]

   (R¹⁸-S(=O)₂)₃CH [10]
[In General Formula [10], R¹⁸'s each independently represent a group selected from the group consisting of a monovalent hydrocarbon group having 1 to 8 carbon atoms, in which a part or all of hydrogen elements may be substituted with a fluorine element, and a fluorine element.]

   ((R¹⁹-S(=O)₂)₃C)_{w}Si(H)ₓ(R²⁰)_{4-w-x} [11]
[In General Formula [11], R¹⁹'s each independently represent a group selected from the group consisting of a monovalent hydrocarbon group having 1 to 8 carbon atoms, in which a part or all of hydrogen elements may be substituted with a fluorine element, and a fluorine element, R²⁰'s each independently represent a monovalent hydrocarbon group having 1 to 18 carbon atoms, in which a part or all of hydrogen elements may be substituted with a fluorine element, w represents an integer of 1 to 3, x represents an integer of 0 to 2, and a sum of w and x is 3 or less.]

In addition, examples of the above-described acid imidized product that can be used as a catalytic compound include compounds having a chemical structure in which an acid such as a carboxylic acid or a phosphoric acid is imidized.

In addition, examples of the above-described nitrogen-containing compound that can be used as a catalytic compound include at least one kind of compounds represented by General Formulae [12] and [13].

R²¹-N=C(NR²²₂)₂ [12]

R²¹-N=C(NR²²₂)R²² [13]

[In General Formulae [12] and [13], R²¹ is selected from a hydrogen group, a -C≡N group, a -NO₂ group, an alkylsilyl group, and a hydrocarbon group in which a part or all of hydrogen elements may be substituted with a fluorine element, where although the hydrocarbon group may have an oxygen atom and/or a nitrogen atom, the hydrocarbon group has an acyclic structure in a case of containing a nitrogen atom. R²² each independently is selected from a hydrogen group, a -C≡N group, a -NO₂ group, and a hydrocarbon group in which part or all of hydrogen elements may be substituted with fluorine elements, the hydrocarbon group may have an oxygen atom and/or a nitrogen atom, and in a case of including a nitrogen atom, R²² has an acyclic structure.]
In addition, examples of the above-described nitrogen-containing compound include compounds having a guanidine skeleton, such as guanidine, 1,1,3,3-tetramethylguanidine, 2-tert-butyl-1,1,3,3-tetramethylguanidine, 1,3-diphenylguanidine, 1,2,3-triphenylguanidine, N, N'-diphenylformamidine, and 2,2,3,3,3-pentafluoropropylamidine.

In addition, examples of the nitrogen-containing heterocyclic compound not containing a silicon atom and the silylated heterocyclic compound, which can be used as a catalytic compound, include at least one kind of compounds represented by General Formulae [14] and [15]. 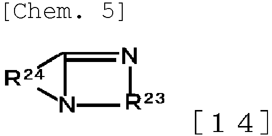
[In General Formula [14], R²³ and R²⁴ each independently represent a divalent organic group consisting of a carbon element and/or a nitrogen element, and a hydrogen element, the total number of carbon atoms and nitrogen atoms is 1 to 9, and in a case of 2 or more, a carbon element which does not form a ring may be present.] 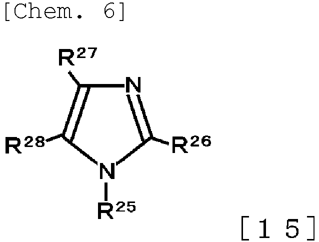
[In General Formula [15], R²⁵ represents an alkyl group having 1 to 6 carbon atoms, in which a part or all of hydrogen elements may be substituted with a fluorine element, a trialkylsilyl group having an alkyl group having 1 to 8 carbon atoms, in which a part or all of hydrogen elements may be substituted with a fluorine element, an alkenyl group having 2 to 6 carbon atoms, in which a part or all of hydrogen elements may be substituted with a fluorine element, an alkoxy group having 1 to 6 carbon atoms, in which a part or all of hydrogen elements may be substituted with a fluorine element, an amino group, an alkylamino group having an alkyl group having 1 to 6 carbon atoms, in which a part or all of hydrogen elements may be substituted with a fluorine element, a dialkylamino group having an alkyl group having 1 to 6 carbon atoms, in which a part or all of hydrogen elements may be substituted with a fluorine element, an aminoalkyl group having 1 to 6 carbon atoms, in which a part or all of hydrogen elements may be substituted with a fluorine element, a nitro group, a cyano group, a phenyl group, a benzyl group, or a halogen group, and R²⁶, R²⁷, and R²⁸ each independently represent an alkyl group having 1 to 6 carbon atoms, in which a part or all of hydrogen elements may be substituted with a fluorine element, or a hydrogen group.]

In addition, the above-described nitrogen-containing heterocyclic compound not containing a silicon atom may include, in the ring, a heteroatom other than the nitrogen atom, such as an oxygen atom and a sulfur atom, may have aromaticity, or may be a compound in which two or more of a plurality of rings are single-bonded or are bonded to each other through a polyvalent linking group of di- or higher valent. In addition, the above-described nitrogen-containing heterocyclic compound not containing a silicon atom may have a substituent.

Examples of the above-described nitrogen-containing heterocyclic compound not containing a silicon atom include pyridine, pyridazine, pyrazine, pyrimidine, triazine, tetrazine, pyrrole, pyrazole, imidazole, triazole, tetrazole, oxazole, isoxazole, thiazole, isothiazole, oxadiazole, thiadiazole, quinoline, isoquinoline, cinnoline, phthalazine, quinoxaline, quinazoline, indole, indazole, benzimidazole, benzotriazole, benzoxazole, benzisoxazole, benzothiazole, benzisothiazole, benzoxadiazole, benzothiadiazole, saccharin, pyrrolidine, and piperidine.

In addition, examples of the above-described silylated heterocyclic compound include a silylated imidazole compound and a silylated triazole compound. An example of the silylated heterocyclic compound includes monomethylsilyl imidazole, dimethylsilyl imidazole, trimethylsilyl imidazole, monomethylsilyl triazole, dimethylsilyl triazole, or trimethylsilyl triazole.

It is noted that although the above-described silylated heterocyclic compound may correspond to the above-described silylating agent, the silylated heterocyclic compound is intended to mean that, in a case of being used as a catalytic compound, the silylated heterocyclic compound is used in combination with another silylating agent other than the silylated heterocyclic compound.

In the above-described silylation composition, a concentration of the silylating agent or a total concentration of the silylating agent and the catalytic compound may be, for example, 0.01% by mass to 100% by mass and is preferably 0.1% by mass to 50% by mass, and more preferably 0.5% by mass to 30% by mass with respect to 100% by mass of the silylation composition.

In addition, in a case where the silylation composition is a liquid, the silylation composition may contain a solvent.

The above-described solvent is not particularly limited as long as it dissolves the above-described silylating agent. As the solvent, for example, organic solvents such as hydrocarbons, esters, ethers, ketones, halogen element-containing solvents, sulfoxide-based solvents, alcohols, carbonate-based solvents, derivatives of polyhydric alcohol, nitrogen element-containing solvents, silicone solvents, and thiols are used. Among these, hydrocarbons, esters, ethers, halogen element-containing solvents, sulfoxide-based solvents, or derivatives of polyhydric alcohol having no OH group, are preferable.

These may be used alone, or two or more thereof may be used in combination.

Examples of the above-described hydrocarbons include linear, branched, or cyclic hydrocarbon-based solvents, aromatic hydrocarbon-based solvents, and terpene-based solvents, and specific examples thereof include n-hexane, n-heptane, n-octane, n-nonane, n-decane, n-undecane, n-dodecane, n-tetradecane, n-hexadecane, n-octadecane, n-icosane, branched hydrocarbon corresponding to the number of carbon atoms thereof (for example, isododecane, isocetane, and the like), cyclohexane, methylcyclohexane, decalin, benzene, toluene, xylene, (ortho-, meta-, or para-)diethylbenzene, 1,3,5-trimethylbenzene, naphthalene, mesitylene, p-menthane, o-menthane, m-menthane, diphenylmenthane, limonene, α-terpinene, β-terpinene, γ-terpinene, bornane, norbornane, pinane, α-pinene, β-pinene, carane, longifolene, abietane, and a terpene-based solvent.

Examples of the above-described esters include ethyl acetate, n-propyl acetate, i-propyl acetate, n-butyl acetate, i-butyl acetate, n-pentyl acetate, i-pentyl acetate, n-hexyl acetate, n-heptyl acetate, n-octyl acetate, n-pentyl formate, n-butyl propionate, ethyl butyrate, n-propyl butyrate, i-propyl butyrate, n-butyl butyrate, methyl n-octanate, methyl decanoate, methyl pyruvate, ethyl pyruvate, n-propyl pyruvate, methyl acetoacetate, ethyl acetoacetate, ethyl 2-oxobutanoate, dimethyl adipate, methyl 3-methoxypropionate, ethyl 3-methoxypropionate, methyl 3-ethoxypropionate, ethyl 3-ethoxypropionate, and ethyl ethoxyacetate.

In addition, as the above-described esters, cyclic esters such as a lactone compound may be used. Examples of the lactone compound include β-propiolactone, γ-butyrolactone, γ-valerolactone, γ-hexanolactone, γ-heptanolactone, γ-octanolactone, γ-nonanolactone, γ-decanolactone, γ-undecanolactone, γ-dodecanolactone, δ-valerolactone, δ-hexanolactone, δ-octanolactone, δ-nonanolactone, δ-decanolactone, δ-undecanolactone, δ-dodecanolactone, and ε-hexanolactone.

Examples of the above-described ethers include di-n-propyl ether, ethyl-n-butyl ether, di-n-butyl ether, ethyl-n-amyl ether, di-n-amyl ether, ethyl-n-hexyl ether, di-n-hexyl ether, di-n-octyl ether, diisopropyl ethers corresponding to the number of carbon atoms thereof, ethers with branched hydrocarbon groups, such as diisoamyl ether, dimethyl ether, diethyl ether, methyl ethyl ether, methyl cyclopentyl ether, diphenyl ether, tetrahydrofuran, and dioxane.

Examples of the above-described ketones include acetone, acetylacetone, methyl ethyl ketone, methyl propyl ketone, methyl butyl ketone, 2-heptanone, 3-heptanone, cyclohexanenone, and isophorone.

Examples of the above-described halogen element-containing solvent include perfluorocarbons such as perfluorooctane, perfluorononane, perfluorocyclopentane, perfluorocyclohexane, and hexafluorobenzene; hydrofluorocarbons such as 1,1,1,3,3-pentafluorobutane, octafluorocyclopentane, 2,3-dihydrodecafluoropentane, and ZEORORA H (manufactured by ZEON CORPORATION); hydrofluoroethers such as methyl perfluoropropyl ether, methyl perfluoroisobutyl ether, methyl perfluorobutyl ether, ethyl perfluorobutyl ether, ethyl perfluoroisobutyl ether, methyl perfluorohexyl ether, ethyl perfluorohexyl ether, Asahiklin AE-3000 (manufactured by AGC Inc.), Novec HFE-7100, Novec HFE-7200, Novec 7300, and Novec 7600 (all manufactured by 3M); chlorocarbons such as tetrachloromethane; hydrochlorocarbons such as chloroform; chlorofluorocarbons such as dichlorodifluoromethane; hydrochlorofluorocarbons such as 1,1-dichloro-2,2,3,3,3-pentafluoropropane, 1,3-dichloro-1,1,2,2,3-pentafluoropropane, 1-chloro-3,3,3-trifluoropropene, and 1,2-dichloro-3,3,3-trifluoropropene; perfluoroether, and perfluoropolyether.

Examples of the above-described sulfoxide-based solvent include dimethyl sulfoxide.

Examples of the above-described carbonate-based solvent include dimethyl carbonate, ethylmethyl carbonate, diethyl carbonate, and propylene carbonate.

Examples of the above-described alcohols include methanol, ethanol, 1-propanol, 2-propanol, 1-butanol, 2-butanol, isobutanol, tert-butanol, 1-pentanol, 2-pentanol, 3-pentanol, 2-methyl-1-butanol, 3-methyl-1-butanol, 2-methyl-2-butanol, 3-methyl-2-butanol, 1-hexanol, 2-hexanol, 3-hexanol, 2-methyl-1-pentanol, 3-methyl-1-pentanol, 4-methyl-1-pentanol, 2-methyl-2-pentanol, 3-methyl-2-pentanol, 4-methyl-2-pentanol, 2-methyl-3-pentanol, 3-methyl-3-pentanol, 2,2-dimethyl-1-butanol, 3,3-dimethyl-1-butanol, 3,3-dimethyl-2-butanol, 2-ethyl-1-butanol, 1-heptanol, 2-heptanol, 3-heptanol, 4-heptanol, benzyl alcohol, 1-octanol, isooctanol, 2-ethyl-1-hexanol, and 4-methyl-2-pentanol.

Examples of the derivative of the above-described polyhydric alcohol having no OH group include ethylene glycol dimethyl ether, ethylene glycol diethyl ether, ethylene glycol dibutyl ether, ethylene glycol monomethyl ether acetate, ethylene glycol monoethyl ether acetate, ethylene glycol monobutyl ether acetate, ethylene glycol diacetate, diethylene glycol dimethyl ether, diethylene glycol ethylmethyl ether, diethylene glycol diethyl ether, diethylene glycol butylmethyl ether, diethylene glycol dibutyl ether, diethylene glycol monomethyl ether acetate, diethylene glycol monoethyl ether acetate, diethylene glycol monobutyl ether acetate, diethylene glycol diacetate, triethylene glycol dimethyl ether, triethylene glycol diethyl ether, triethylene glycol dibutyl ether, triethylene glycol butylmethyl ether, triethylene glycol monomethyl ether acetate, triethylene glycol monoethyl ether acetate, triethylene glycol monobutyl ether acetate, triethylene glycol diacetate, tetraethylene glycol dimethyl ether, tetraethylene glycol diethyl ether, tetraethylene glycol dibutyl ether, tetraethylene glycol monomethyl ether acetate, tetraethylene glycol monoethyl ether acetate, tetraethylene glycol monobutyl ether acetate, tetraethylene glycol diacetate, propylene glycol dimethyl ether, propylene glycol diethyl ether, propylene glycol dibutyl ether, propylene glycol monomethyl ether acetate, propylene glycol monoethyl ether acetate, propylene glycol monobutyl ether acetate, propylene glycol diacetate, dipropylene glycol dimethyl ether, dipropylene glycol methyl propyl ether, dipropylene glycol diethyl ether, dipropylene glycol dibutyl ether, dipropylene glycol monomethyl ether acetate, dipropylene glycol monoethyl ether acetate, dipropylene glycol monobutyl ether acetate, dipropylene glycol diacetate, tripropylene glycol dimethyl ether, tripropylene glycol diethyl ether, tripropylene glycol dibutyl ether, tripropylene glycol monomethyl ether acetate, tripropylene glycol monoethyl ether acetate, tripropylene glycol monobutyl ether acetate, tripropylene glycol diacetate, tetrapropylene glycol dimethyl ether, tetrapropylene glycol monomethyl ether acetate, tetrapropylene glycol diacetate, butylene glycol dimethyl ether, butylene glycol monomethyl ether acetate, butylene glycol diacetate, glycerin triacetate, 3-methoxybutyl acetate, 3-methyl-3-methoxybutyl acetate, and 3-methyl-3-methoxybutyl propionate.

Examples of the above-described nitrogen element-containing solvent include formamide, N,N-dimethylformamide, N,N-dimethylacetamide, N-methyl-2-pyrrolidone, N-ethyl-2-pyrrolidone, N-propyl-2-pyrrolidone, 1,3-dimethyl-2-imidazolidinone, 1,3-diethyl-2-imidazolidinone, 1,3-diisopropyl-2-imidazolidinone, diethylamine, triethylamine, and pyridine.

Examples of the above-described silicone solvent include hexamethyldisiloxane, octamethyltrisiloxane, decamethyltetrasiloxane, and dodecamethylpentasiloxane.

Examples of the above-described thiols include 1-hexanethiol, 2-methyl-1-pentanethiol, 3-methyl-1-pentanethiol, 4-methyl-1-pentanethiol, 2,2-dimethyl-1-butanethiol, 3,3-dimethyl-1-butanethiol, 2-ethyl-1-butanethiol, 1-heptanethiol, benzylthiol, 1-octanethiol, 2-ethyl-1-hexanethiol, 1-nonanethiol, 1-decanethiol, 1-undecanethiol, 1-dodecanethiol, and 1-tridecanethiol.

The above-described solvent preferably includes an aprotic solvent. The content of the aprotic solvent is, for example, 80% by mass or more, preferably 90% by mass or more in 100% by mass of the above-described solvent. It is more preferable that the above-described solvent is the aprotic solvent, that is, the solvent includes the aprotic solvent such that the content of the aprotic solvent is 100% by mass in 100% by mass in the solvent.

The aprotic solvent includes hydrocarbons, esters, ethers, ketones, halogen element-containing solvents, sulfoxides, carbonate solvents, derivatives of polyhydric alcohol, nitrogen element-containing solvents, and silicone solvents. These may be used alone, or two or more thereof may be used in combination.

Among these, it is preferable to use one or two or more kinds selected from the group consisting of derivatives of polyhydric alcohol, hydrocarbons, and ethers.

From the viewpoint of cost and solubility, a derivative of polyhydric alcohol (however, those having no OH group in the molecule) are preferable, and for example, diethylene glycol monoethyl ether acetate, ethylene glycol monomethyl ether acetate, propylene glycol monomethyl ether acetate, diethylene glycol dimethyl ether, diethylene glycol ethyl methyl ether, diethylene glycol diethyl ether, diethylene glycol monomethyl ether acetate, diethylene glycol diacetate, triethylene glycol dimethyl ether, ethylene glycol diacetate, ethylene glycol dimethyl ether, 3-methoxy-3-methyl-1-butyl acetate, propylene glycol dimethyl ether, propylene glycol diethyl ether, propylene glycol dibutyl ether, propylene glycol monoethyl ether acetate, propylene glycol monobutyl ether acetate, propylene glycol diacetate, dipropylene glycol dimethyl ether, dipropylene glycol methyl propyl ether, dipropylene glycol diethyl ether, dipropylene glycol dibutyl ether, dipropylene glycol monomethyl ether acetate, dipropylene glycol monoethyl ether acetate, dipropylene glycol monobutyl ether acetate, or dipropylene glycol diacetate is preferable. In addition, propylene carbonate, a linear or branched hydrocarbon-based solvent having 6 to 12 carbon atoms, p-menthane, diphenylmenthane, limonene, terpinene, bornane, norbornane, pinane, or the like is also preferable.

As an example of the silylation composition containing a silylating agent and a solvent, for example, compositions in which the silylating agent includes one or two or more kinds selected from the group consisting of hexamethyldisilazane, heptamethyldisilazane, N-(trimethylsilyl)dimethylamine, bis(dimethylamino)dimethylsilane, bis(trimethylsilyl)trifluoroacetamide, N-methyl-N-trimethylsilyltrifluoroacetamide, N-trimethylsilylacetamide, N-trimethylsilylimidazole, trimethylsilyltriazole, bistrimethylsilylsulfate, 2,2,5,5-tetramethyl-2,5-disila-1-azacyclopentane, 2,2,4,4,6,6-hexamethylcyclotrisilazane, hexamethyldisiloxane, trimethylsilyltrifluoroacetate, trimethylsilyltrifluoromethanesulfonate, trimethylsilylbenzenesulfonate, and trimethylsilyltoluenesulfonate, and the solvent includes one or two or more kinds selected from the group consisting of propylene carbonate, linear hydrocarbon-based solvents having 7 to 10 carbon atoms, menthane, pinane, γ-butyrolactone, propylene glycol monomethyl ether acetate, and 3-methoxy-3-methyl-1-butylacetate may be used.

The silylation composition may not contain water or may contain water such that the content of water is 2% by mass or less in 100% by mass of the silylation composition. In this way, a silylation composition that is substantially free of water can be used.

The above-described silylation composition can contain a component other than the above-described components as long as the object of the present invention is not impaired. Examples of other components include oxidizing agents such as hydrogen peroxide and ozone, surfactants, and antioxidants such as BHT.

The silylation composition according to the present embodiment is obtained by mixing each of the components described above. The obtained mixed liquid may be purified using an adsorbent, a filter, or the like as necessary. In addition, each component may be purified in advance by distillation and also purified by using an adsorbent, a filter, or the like.

As described above, the embodiments according to the present invention have been described; however, these are examples according to the present invention, and thus it is possible to adopt various configurations other than the above. In addition, the present invention is not limited to the embodiments described above and modifications, improvements, and the like are included in the present invention in a range in which it is possible to achieve the object of the present invention.

### Examples

Hereinafter, the present invention will be described in detail with reference to Examples; however, the present invention is not limited to the description of these Examples.

### <Treatment of substrate>

Using the combination of the substrate and the treatment conditions shown in Table 1, the substrate prepared according to the following (1. Preparation step for substrate) was subjected to, in the following order, the pretreatment A, the silylation treatment B, and the removal treatment C, which are shown in the following (2. Surface modification step), whereby the treatment of the substrate was carried out. It is noted that, hereinafter, "SiOx" indicates silicon oxide, SiN indicates silicon nitride, SiGe indicates silicon germanium, and the compositional ratio thereof is not necessarily limited to Si:N = 1:1 or Si:Ge = 1:1. In addition, all the following tests are simulated tests in which a substrate having two kinds of surfaces was not treated but a substrate regarded as the first surface and a substrate regarded as the second surface were separately prepared in a simple manner and then subjected to the treatment.

### [Table 1]

**Table 1**

| Test No. | Substrate | Pretreatment A | Silylation treatment B | Removal treatment C | Water contact angle (°) | | | Silylation rate | Water contact angle (°) | | | Water repellency Retention/ reduction | Water repellency after water repellency adjustment |
|---|---|---|---|---|---|---|---|---|---|---|---|---|---|
| | Composition of Si-based surface | Condition | Kind | Condition | Treatment A (P) | Treatment B (R) | (R - P)/P | | Treatment C (Q) | ΔQ - R | Q/P | | |
| 1-1 | Si | A-1 | B-1 | C-1 | 77 | 87 | 0.1 | C | 43 | -44 | 0.6 | - | C |
| 1-2 | SiOx | A-1 | B-1 | C-1 | 12 | 85 | 6.1 | A | 80 | -5 | 6.7 | + | A |
| 1-3 | SiN | A-1 | B-1 | C-1 | 19 | 53 | 1.8 | B | 22 | -31 | 1.2 | - | B |
| 1-4 | SiGe | A-1 | B-1 | C-1 | 13 | 50 | 2.8 | B | 13 | -37 | 1.0 | - | C |
| 2-1 | Si | A-2a | B-1 | C-1 | 5 | 91 | 17.2 | A | 91 | 0 | 18.2 | + | A+ |
| 2-2 | SiOx | A-2a | B-1 | C-1 | 7 | 91 | 12.0 | A | 91 | 0 | 13.0 | + | A+ |
| 2-3 | SiN | A-2a | B-1 | C-1 | 2 | 90 | 44.0 | A | 85 | -5 | 42.5 | + | A+ |
| 2-4 | SiGe | A-2a | B-1 | C-1 | 3 | 51 | 16.0 | A | 7 | -44 | 2.3 | - | B |
| 3-1 | Si | A-2b | B-1 | C-1 | 5 | 86 | 16.2 | A | 81 | -5 | 16.2 | + | A+ |
| 3-2 | SiOx | A-2b | B-1 | C-1 | 5 | 89 | 16.8 | A | 87 | -2 | 17.4 | + | A+ |
| 3-3 | SiN | A-2b | B-1 | C-1 | 12 | 65 | 4.4 | B | 16 | -49 | 1.3 | - | B |
| 3-4 | SiGe | A-2b | B-1 | C-1 | 7 | 55 | 6.9 | A | 13 | -42 | 1.9 | - | B |
| 4-1 | SiOx | A-1 | B-1 | C-2 | 12 | 85 | 6.1 | A | 80 | -5 | 6.7 | + | A |
| 4-2 | SiN | A-1 | B-1 | C-2 | 19 | 53 | 1.8 | B | 27 | -26 | 1.4 | - | B |
| 5-1 | SiOx | A-1 | B-2 | C-3 | 12 | 90 | 6.5 | A | 85 | -5 | 7.1 | + | A |
| 5-2 | SiN | A-1 | B-2 | C-3 | 19 | 55 | 1.9 | B | 25 | -30 | 1.3 | - | B |
| 6-1 | SiOx | A-1 | B-1 | C-4 | 12 | 85 | 6.1 | A | 81 | -4 | 6.8 | + | A |
| 6-2 | SiN | A-1 | B-1 | C-4 | 19 | 53 | 1.8 | B | 19 | -34 | 1.0 | - | B |
| 7-1 | SiOx | A-1 | B-1 | C-5 | 12 | 85 | 6.1 | A | 79 | -6 | 6.6 | + | A |
| 7-2 | SiN | A-1 | B-1 | C-5 | 19 | 53 | 1.8 | B | 20 | -33 | 1.1 | - | B |
| 8-1 | SiOx | A-1 | B-1 | C-6 | 12 | 85 | 6.1 | A | 78 | -7 | 6.5 | + | A |
| 8-2 | SiN | A-1 | B-1 | C-6 | 19 | 53 | 1.8 | B | 20 | -33 | 1.1 | - | B |
| 9-1 | SiOx | A-1 | B-1 | C-7 | 12 | 85 | 6.1 | A | 81 | -4 | 6.8 | + | A |
| 9-2 | SiN | A-1 | B-1 | C-7 | 19 | 53 | 1.8 | B | 24 | -29 | 1.3 | - | B |
| 10-1 | SiOx | A-1 | B-3 | C-8 | 12 | 86 | 6.2 | A | 84 | -2 | 7.0 | + | A |
| 10-2 | SiN | A-1 | B-3 | C-8 | 19 | 53 | 1.8 | B | 40 | -13 | 2.1 | - | B |
| 11-1 | SiOx | A-1 | B-3 | C-1 | 12 | 86 | 6.2 | A | 82 | -4 | 6.8 | + | A |
| 11-2 | SiN | A-1 | B-3 | C-1 | 19 | 53 | 1.8 | B | 26 | -27 | 1.4 | - | B |
| 12-1 | SiOx | A-1 | B-4 | C-1 | 12 | 94 | 6.8 | A | 85 | -9 | 7.1 | + | A |
| 12-2 | SiN | A-1 | B-4 | C-1 | 19 | 90 | 3.7 | B | 30 | -60 | 1.6 | - | B |

### (1. Preparation step for substrate)

A substrate having the Si-based surface composition shown in Table 1 was prepared as follows.

As the substrate, a smooth silicon substrate having a size of 30 mm × 40 mm × 1 mm was used. In a case of having a surface composition of Si, the substrate to be used was used as it was, and in a case of having another surface composition, the surface of the substrate was subjected to the formation of a film having a desired surface composition.

### (2. Surface modification step)

Treatment conditions for each treatment that is used in the surface modification step are as follows.

### (2.1) Pretreatment A

### (A-1) Removal of natural oxidation film

The substrate was immersed in an aqueous solution of 0.02% to 1% by mass of hydrofluoric acid (DHF) for 1 minute at room temperature, and subsequently immersed in pure water for 1 minute and then in 2-propanol (IPA) for 1 minute, as rinsing liquids.

(A-2a) Oxidation step for substrate surface The substrate was installed in a UV/O₃ device (manufactured by Novascan Technologies), and the surface of the substrate was subjected to a UV/O₃ treatment for 30 minutes.

(A-2b) Removal of natural oxidation film and oxidation of substrate surface

The substrate was immersed in an aqueous solution of 0.02% to 1% by mass of hydrofluoric acid (DHF) for 1 minute at room temperature and subsequently immersed in an APM solution (a mixed solution of NH₃OH:H₂O₂:H₂O = 1:10:70) for 1 minute. Then, the substrate was subsequently immersed in pure water for 1 minute and then in IPA for 1 minute.

### (2.2) Silylation treatment B

The substrate was immersed at room temperature in a silylating agent prepared by the following method, and the surface of the substrate was subjected to a silylation treatment. However, in a case where the silylating agent was B-1, B-3, or B-4, the immersion time was set to 60 seconds, and in a case where the silylating agent was B-2, the immersion time was set to 20 seconds.

### (Silylating agent B-1)

A silylating agent B-1 was obtained by weighing each of 5 g of hexamethyldisilazane (HMDS), 0.1 g of trimethylsilyl trifluoroacetate, and 94.9 g of propylene glycol monomethyl ether acetate (PGMEA) and then mixing them at room temperature.

### (Silylating agent B-2)

A silylating agent B-2 was obtained by weighing each of 12 g of HMDS, 4 g of trimethylsilyl trifluoroacetate, and 84 g of PGMEA and then mixing them at room temperature.

### (Silylating agent B-3)

A silylating agent B-3 was obtained by weighing each of 7 g of 1,3-dibutyl-1,1,3,3-tetramethyldisilazane, 0.3 g of butyldimethylsilyltrifluoroacetate, and 92.7 g of PGMEA and then mixing them at room temperature.

### (Silylating agent B-4)

A silylating agent B-4 was obtained by weighing each of 9 g of hexamethyldisilazane (HMDS) 1,3-dioctyl-1,1,3,3-tetramethyldisilazane, 0.5 g of octyldimethylsilyl trifluoroacetate, and 90.5 g of PGMEA and then mixing them at room temperature.

### (2.3) Removal treatment C

(C-1) Treatment with base aqueous solution The substrate was immersed in an aqueous solution of 3% by mass of triethylamine for 30 minutes at room temperature. Next, the substrate was immersed in pure water for 1 minute and then in IPA for 1 minute. Thereafter, the substrate was taken out, and air was blown to remove IPA, whereby the substrate was dried.

(C-2) Treatment with diluted hydrogen fluoride water The substrate was immersed in an aqueous solution of 0.01% to 0.5% by mass of hydrogen fluoride for 5 minutes at room temperature. Next, the substrate was immersed in pure water for 1 minute and then in IPA for 1 minute. Thereafter, the substrate was taken out, and air was blown to remove IPA, whereby the substrate was dried.

(C-3) Treatment with base aqueous solution The substrate was immersed in an aqueous solution of 3% by mass of triethylamine for 10 minutes at room temperature. Next, the substrate was immersed in pure water for 1 minute and then in IPA for 1 minute. Thereafter, the substrate was taken out, and air was blown to remove IPA, whereby the substrate was dried.

(C-4) Treatment with base aqueous solution The substrate was immersed in an aqueous solution of 3% by mass of diisopropylamine for 30 minutes at room temperature. Next, the substrate was immersed in pure water for 1 minute and then in IPA for 1 minute. Thereafter, the substrate was taken out, and air was blown to remove IPA, whereby the substrate was dried.

(C-5) Treatment with base aqueous solution The substrate was immersed in an aqueous solution of 3% by mass of N,N-dimethylisopropylamine for 30 minutes at room temperature. Next, the substrate was immersed in pure water for 1 minute and then in IPA for 1 minute. Thereafter, the substrate was taken out, and air was blown to remove IPA, whereby the substrate was dried.

(C-6) Treatment with base aqueous solution The substrate was immersed in an aqueous solution of 3% by mass of N,N-diethylmethylamine for 30 minutes at room temperature. Next, the substrate was immersed in pure water for 1 minute and then in IPA for 1 minute. Thereafter, the substrate was taken out, and air was blown to remove IPA, whereby the substrate was dried.

(C-7) Treatment with base aqueous solution The substrate was immersed in an aqueous solution of 3% by mass of N,N-diisopropylethylamine for 30 minutes at room temperature. Next, the substrate was immersed in pure water for 1 minute and then in IPA for 1 minute. Thereafter, the substrate was taken out, and air was blown to remove IPA, whereby the substrate was dried.

(C-8) Treatment with base aqueous solution The substrate was immersed in an aqueous solution of 10% by mass of tetrabutylammonium hydroxide for 1 minute at room temperature. Next, the substrate was immersed in pure water for 1 minute and then in IPA for 1 minute. Thereafter, the substrate was taken out, and air was blown to remove IPA, whereby the substrate was dried.

The following items were evaluated using the substrate in the treatment process or after the treatment of <Treatment of substrate> described above.

### <Measurement and evaluation of water contact angle> (Measurement of water contact angle)

According to the following measurement procedure, the water contact angle (°) on the surface of the substrate was measured at each of the following timings: immediately after the pretreatment A, immediately after the silylation treatment B, and immediately after the removal treatment C.

· Measuring method immediately after pretreatment A: First, in a case where the substrate immediately after the treatment was wet, air was blown to dry the substrate. Next, the surface of the substrate, which had been subjected to the treatment A, was placed horizontally with the surface facing upward, and a water droplet of 2 µl of pure water was placed on the surface. Next, in accordance with JIS R 3257:1999 "Testing method of wettability of surface of glass substrate", an angle (water contact angle) formed by a water droplet and the substrate was measured with a contact angle meter (manufactured by Kyowa Interface Science Co., Ltd.: CA-X type). In addition, the temperature during the measurement was set to room temperature (25°C).

### · Measuring method immediately after silylation treatment B:

First, the substrate immediately after the treatment was immersed in IPA at 25°C for 1 minute. Next, the substrate was dried by blowing air thereon, and the water contact angle was measured by the same step as in the measurement immediately after the pretreatment A.

### · Measuring method after removal treatment C:

The surface of the substrate, which had been subjected to the silylation treatment B, was placed horizontally with the surface facing upward, and the water contact angle was measured by the same step as in the measurement immediately after the pretreatment A.

### (Evaluation of silylation rate)

The increase rate in water repellency on the substrate surface due to the silylation treatment B was evaluated based on the following evaluation standards using a "silylation rate", which is determined from "(R - P)/P" by using a water contact angle (P) immediately before the silylation treatment B (immediately after the pretreatment A in the present example) and a water contact angle (R) immediately after the silylation treatment B.
Large (A): A case where the silylation rate is 5.0 or more
Small (B): A case where the silylation rate is more than 1.0 and less than 5.0
Very small or none (C): A case where the silylation rate is 1.0 or less

### (Evaluation of retention/reduction of water repellency)

The retention or reduction of the water repellency on the substrate surface due to the removal treatment C was evaluated based on the following evaluation standards using the "amount of change in contact angle (ΔQ - R)", which is determined from "water contact angle (Q) immediately after removal treatment C - water contact angle (R) immediately after silylation treatment **B".**
Retention (+): A case where the amount of change in contact angle (ΔQ - R) is -10° or more
Reduction (-): A case where the amount of change in contact angle (ΔQ - R) is less than -10°

### (Evaluation of water repellency after adjustment of water repellency)

The change in water repellency before and after the treatment in a case where the treatment was carried out through the silylation treatment B and the removal treatment C was evaluated. Specifically, the evaluation was carried out based on the following evaluation standards using the improvement rate of water repellency (Q/P)", which is determined from "water contact angle (Q) immediately after removal treatment C/water contact angle (P) immediately before silylation treatment B (immediately after pretreatment A in present example)".
Excellent (A+): A case where the improvement rate of water repellency (Q/P) is 10.0 or more
Good (A): A case where the improvement rate of water repellency (Q/P) is 5.0 or more and less than 10.0
Acceptable (B): A case where the improvement rate of water repellency (Q/P) is more than 1.0 and less than 5.0
None or reduced (C): A case where the improvement rate of water repellency (Q/P) is 1.0 or less

Here, the speculation by the inventors of the present invention regarding the above-described water contact angle will be described.

In a case where the silylation rate before and after the silylation treatment B is large (A), the Si-based surface is protected with a silyl group, that is, a water repellent film is formed. In addition, in a case of being small (B), the water repellent film is partially formed, or a compound derived from the silylating agent is present. In addition, in a case of very small or none (C), the water repellent film or the like does not exist to such an extent that it has a significant effect on the water repellency.

It can be said that the water repellent film is removed (-) as the amount of change in contact angle (ΔQ - R) before and after the removal treatment C is negatively larger, and the water repellent film is maintained (+) as the amount of change in contact angle (ΔQ - R) before and after the removal treatment C is negatively smaller.

In a case where the improvement rate of water repellency (Q/P) before and after the treatment is excellent (A+) or good (A) in a case where the treatment was carried out through the silylation treatment B and the removal treatment C, it can be said that the surface is modified in a direction in which the water repellency is improved. In a case of being acceptable (B) or very small or none (C), it can be said that the low water repellency is maintained or the surface is modified in a direction in which the water repellency is reduced.

Based on such a speculation, the evaluation of the treatment result of each test No. is summarized.

From test Nos. 1-1 to 1-4 in Table 1, the water repellent film can be maintained on the SiOx surface by combining the pretreatment (A-1) and the removal treatment (C-1), and the water repellency can be reduced by removing the water repellent film from the other surfaces such as the Si surface, the SiN surface, and the SiGe surface. In addition, immediately after the silylation treatment B, although the water repellent film is formed on the SiOx surface, a water repellent film or a compound derived from the silylating agent, that can be removed by the removal step C, is present on the SiN surface and the SiGe surface, and thus it can be said that the water repellent film or the like present on the Si surface is slight.

In addition, in Nos. 4-1 and 4-2, the same results can be obtained although the removal treatment for Nos. 1-2 and 1-3 has been carried out in (C-2) instead of (C-1).

In addition, in each of Nos. 6-1 and 6-2 to Nos. 9-1 and 9-2, the same results can be obtained although the removal treatment in Nos. 1-2 and 1-3 has been carried out in (C-4) to (C-7) instead of (C-1).

In addition, in each of Nos. 5-1 and 5-2, and Nos. 10-1 and 10-2 to Nos. 12-1 and 12-2, the same results can be obtained although a silylating agent which is different from the silylating agents used in Nos. 1-2 and 1-3 and the removal treatment are used.

In addition, from Nos. 2-1 to 2-4, the water repellent film can be maintained on the Si surface, the SiOx surface, and the SiN surface by combining the pretreatment (A-2a) and the removal treatment (C-1), and the water repellency can be reduced by removing the water repellent film from the SiGe surface. In addition, immediately after the silylation treatment B, a water repellent film can be formed on the Si surface, the SiOx surface, and the SiN surface, and a water repellent film or a compound derived from the silylating agent, that can be removed by the removal step C, is present on the SiGe surface. Further, in a case where (A-2a) is used as the pretreatment, the water repellency can be reduced without going through a step of removing the natural oxidation film of (A-1).

In addition, from Nos. 3-1 to 3-4, the water repellent film can be maintained on the Si surface, the SiOx surface, and the SiN surface by combining the pretreatment (A-2b) and the removal treatment (C-1), and the water repellency can be selectively reduced by removing the water repellent film from the SiGe surface. In addition, immediately after the silylation treatment B, although a water repellent film can be formed on the Si surface, the SiOx surface, and the SiGe surface, and a water repellent film or a compound derived from the silylating agent, that is possible by the removal step C, is present on the SiN surface.

It is presumed as described above.

### (Selection index for reducing water repellency)

A selection index for reducing water repellency by the surface modification step will be considered.

It is considered that there are four transition patterns I to IV in the transition of the water repellency of the surface due to the surface modification step.
- Transition pattern I: A water repellent film is formed and maintained.
- Transition pattern II: Although a water repellent film is formed, water repellency is reduced or removed.
- Transition pattern III: Although the silylation rate is low, or a water repellent film is not formed, and the water repellent film is reduced or removed.
- Transition pattern IV: Although the silylation rate is low, or a water repellent film is not formed, and this state is maintained.

In addition, it is presumed that, by a surface modification step in which a treatment that provides the "transition pattern I" and a treatment that provides at least one of the other transition patterns II to IV are combined, the water repellency of the second surface can be selectively reduced with respect to the first surface.

On the other hand, the water repellency after going through these transition patterns I to IV, that is, the water repellency of the surface after the surface modification step is evaluated using "the improvement rate of water repellency (Q/P)" as shown in "Water repellency after water repellency adjustment" in Table 1, and the evaluation results are classified according to the evaluation standard "A+, A, B, C".

Specifically, it may be considered that the transition pattern I corresponds to "A and A+", the transition pattern II corresponds to "B", and the transition pattern III or IV corresponds to "C".

In this case, since, in Table 1, a case that provides the "transition pattern I" and a case that provides at least one of the other transition patterns II to IV, are combined in any of the treatments of the treatment in Examples Nos. 1-1 to 1-4, the treatment in Examples Nos. 2-1 to 2-4, the treatment in Examples Nos. 3-1 to 3-4, the treatment in Examples Nos. 4-1 and 4-2, the treatment in Examples Nos. 5-1 and 5-2, the treatment in Examples Nos. 6-1 and 6-2, the treatment in Examples Nos. 7-1 and 7-2, the treatment in Examples Nos. 8-1 and 8-2, the treatment in Examples Nos. 9-1 and 9-2, the treatment in Examples Nos. 10-1 and 10-2, the treatment in Examples Nos. 11-1 and 11-2, and the treatment in Examples Nos. 12-1 and 12-2, it can be said that the water repellency of the second surface can be selectively reduced with respect to the first surface.

It is noted that in order for a treatment to provide the "transition pattern I", examples of the treatment include appropriately selecting the pretreatment A, the silylation treatment B, and the removal treatment C such that the silylation rate "(R-P)/P" is 5.0 or more, and "the amount of change in contact angle (ΔQ - R)" is -10° or more by using the evaluation standard "A+" or "A" as an index.

### <Element composition analysis by X-ray photoelectron spectroscopy (XPS)>

The surface of the SiN substrate in the treatment process or after the treatment of <Treatment of substrate> described above was subjected to XPS analysis, and a peak area ratio of each of the Si element, the O element, and the N element was calculated from the obtained XPS spectrum, and then the peak area ratio (%) of each element was defined as the existence proportion of each element composition.

### [Table 2]

**Table 2**

| Substrate | XPS: Composition of substrate surface (%) | | | | Surface modification step | | |
|---|---|---|---|---|---|---|---|
| Composition of surface | Si | O | N | O/(Si + O + N) | Treatment A | Treatment B | Treatment C |
| SiN | 44.8 | 1.0 | 51.7 | 0.010 | A-1 | B-1 | - |
| | 44.8 | 0.1 | 52.1 | 0.001 | A-1 | B-1 | C-1 |
| | 34.6 | 18.2 | 42.1 | 0.192 | A-2a | B-1 | - |
| | 32.0 | 20.9 | 37.3 | 0.232 | A-2a | B-1 | C-1 |

From the above XPS analysis, it is presumed that the peak of the O element on the surface of the SiN substrate indicates the presence of the O element derived from the OH group, which is the point for reaction with the silylating agent. That is, it is considered that the presence of the peak of the O element indicates that the silylation has occurred (that is, the surface has a water repellent film or a compound derived from a silylating agent).

On the SiN surface, the peak of the O element was hardly confirmed on the surface immediately after the silylation treatment B, which had undergone the pretreatment (A-1), and the peak of the O element was further reduced immediately after further carrying out the removal treatment C. As a result, it is considered that the silylated group is not present in a large amount or is removed by the removal treatment C even in a case where the silylation has been carried out.

In addition, in the case of the pretreatment (A-2a), it was confirmed that the peak of the O element is present on the surface immediately after the silylation treatment B as compared with in the case of the pretreatment (A-1), and the peak of the O element remains on the surface even after the removal treatment (C-1). As a result, it can be said that the SiN surface is protected by a silyl group, and the silylated state is maintained. The above results are consistent with the tendency of the water contact angles in the above-described test No. 1-3 and No. 2-3. From the above, it is presumed that in a case where the SiN surface is in a state where the silylation rate is large, the water repellency obtained is maintained even after the removal treatment C.

### <substrate manufacturing method>

### (Film formation by ALD)

Using an ALD device (manufactured by Picosun), a film formation test for titanium oxide was carried out as follows.

First, a plurality of substrates having a predetermined combination were arranged side by side on a pedestal in the ALD device using the substrate obtained in <Treatment of substrate>. It is noted that all of the following tests are simulation tests in which a substrate regarded as the first surface and a substrate regarded as the second surface are arranged in a simple manner.

Specifically, two samples of a substrate having a SiOx surface and a substrate having a SiN surface in the example of each of Examples 1, 3 to 10, Comparative Example 1, and Reference Example 1, and four samples of a substrate having a Si surface, a substrate having a SiOx surface, a substrate having a SiN surface, and a substrate having a SiGe surface in the example of each of Example 2, Comparative Example 2, and Reference Example 2, were arranged side by side on the pedestal in the device in a state of being adjacent to each other.

Subsequently, the substrate was heated to 150°C, and then repeatedly subjected to a predetermined number of cycles, where one cycle was defined as TiCl₄ exposure (supply time: 0.1 s, flow rate: 120 sccm), purging (6 s), H₂O exposure (supply time: 0.1 s, flow rate: 120 sccm), and purging (6 s), in this order. Regarding this film formation cycle, 25 cycles or 50 cycles were carried out.

### [Table 3]

**Table 3**

| | Substrate | | Surface modification step | | | Immediately before film formation test | (S1 - S2)/S2 | Difference in water repellency | Amount of film formation by ALD (nm) | | Speed of film formation | Amount of suppression of film formation | Selectivity of film formation | |
|---|---|---|---|---|---|---|---|---|---|---|---|---|---|---|
| | | Composition of surface | Treatment A | Treatment B | Treatment C | Water contact angle S (°) | | | 25 cycle | 50 cycle | nm/cycle | | Target | Evaluation |
| Example 1 | First surface | SiOx | A-1 | B-1 | C-1 | 80 | 2.6 | Sufficient | 0.00 | 0.29 | 0.006 | 95% | Non-processing | High |
| | Second surface | SiN | A-1 | B-1 | C-1 | 22 | - | - | 2.26 | 5.00 | 0.100 | - 9% | Processing | |
| Comparative Example 1 | First surface | SiOx | A-1 | B-1 | - | 85 | 0.6 | Insufficient | 0.01 | 0.05 | 0.001 | 99% | Non-processing | Low |
| | Second surface | SiN | A-1 | B-1 | - | 53 | - | - | 0.10 | 0.78 | 0.016 | 83% | Processing | |
| Reference Example 1 | | SiOx | A-1 | - | - | 12 | | | 2.12 | 4.98 | 0.129 | | | |
| | | SiN | A-1 | - | - | 19 | | | 1.86 | 5.00 | 0.092 | | | |
| Example 2 | First surface | Si | A-2a | B-1 | C-1 | 91 | 12.0 | Sufficient | 0.00 | 0.00 | 0.000 | 100% | Non-processing | High |
| | First surface | SiOx | A-2a | B-1 | C-1 | 91 | 12.0 | Sufficient | 0.12 | 0.24 | 0.005 | 96% | | |
| | First surface | SiN | A-2a | B-1 | C-1 | 85 | 11.1 | Sufficient | 0.00 | 0.00 | 0.000 | 100% | | |
| | Second surface | SiGe | A-2a | B-1 | C-1 | 7 | - | - | 1.73 | 3.70 | | -6% | Processing | |
| Comparative Example 2 | First surface | Si | A-2a | B-1 | - | 91 | 0.8 | Insufficient | 0.10 | 0.12 | 0.002 | 98% | Non-processing | Low |
| | First surface | SiOx | A-2a | B-1 | - | 91 | 0.8 | Insufficient | 0.01 | 0.00 | 0.074 0.000 | 100% | | |
| | First surface | SiN | A-2a | B-1 | - | 90 | 0.8 | Insufficient | 0.00 | 0.10 | 0.002 | 98% | | |
| | Second surface | SiGe | A-2a | B-1 | - | 51 | - | - | 0.15 | 0.64 | 0.013 | 81% | Processing | |
| Reference Example 2 | | Si | A-2a | | - | 5 | | | 2.38 | 4.44 | 0.089 | | | |
| | | SiOx | A-2a | | - | 7 | | | 2.78 | 6.11 | 0.122 | | | |
| | | SiN | A-2a | - | - | 2 | | | 3.16 | 6.25 | 0.125 | | | |
| | | SiGe | A-2a | - | - | 3 | | | 2.76 | 3.52 | 0.070 | | | |
| Example 3 | First surface | SiOx | A-1 | B-2 | C-3 | 85 | 2.4 | Sufficient | 0.00 | 0.00 | 0.000 | 100% | Non-processing | High |
| | Second surface | SiN | A-1 | B-2 | C-3 | 25 | - | - | 1.90 | 4.40 | 0.090 | 2% | Processing | |
| Example 4 | First surface | SiOx | A-1 | B-1 | C-4 | 81 | 3.3 | Sufficient | 0.10 | 0.10 | 0.004 | 97% | Non-processing | High |
| | Second surface | SiN | A-1 | B-1 | C-4 | 19 | - | - | 2.40 | 5.00 | 0.100 | -9% | Processing | |
| Example 5 | First surface | SiOx | A-1 | B-1 | C-5 | 79 | 3.0 | Sufficient | 0.10 | 0.20 | 0.004 | 97% | Non-processing | High |
| | Second surface | SiN | A-1 | B-1 | C-5 | 20 | - | - | 2.20 | 5.00 | 0.100 | -9% | Processing | |
| Example 6 | First surface | SiOx | A-1 | B-1 | C-6 | 78 | 2.9 | Sufficient | 0.10 | 0.20 | 0.002 | 98% | Non-processing | High |
| | Second surface | SiN | A-1 | B-1 | C-6 | 20 | - | - | 2.20 | 5.00 | 0.100 | -9% | Processing | |
| Exemple 7 | First surface | SiOx | A-1 | B-1 | C-7 | 81 | 2.4 | Sufficient | 0.00 | 0.10 | 0.002 | 98% | Non-processing | High |
| | Second surface | SiN | A-1 | B-1 | C-7 | 24 | - | - | 2.00 | 4.50 | 0.090 | 2% | Processing | |
| Example 8 | First surface | SiOx | A-1 | B-3 | C-8 | 84 | 1.1 | Sufficient | 0.00 | 0.00 | 0.000 | 100% | Non-processing | High |
| | Second surface | SiN | A-1 | B-3 | C-8 | 40 | - | - | 0.40 | 3.40 | 0.070 | 24% | Processing | |
| Example 9 | First surface | SiOx | A-1 | B-3 | C-1 | 82 | 2.2 | Sufficient | 0.00 | 0.00 | 0.000 | 100% | Non-processing | High |
| | Second surface | SiN | A-1 | B-3 | C-1 | 26 | - | - | 1.50 | 4.40 | 0.120 | -30% | Processing | |
| Example 10 | First surface | SiOx | A-1 | B-4 | C-1 | 85 | 1.8 | Sufficient | 0.00 | 0.00 | 0.000 | 100% | Non-processing | High |
| | Second surface | SiN | A-1 | B-4 | C-1 | 30 | - | - | 1.40 | 4.00 | 0.080 | 13% | Processing | |
| Example 11 Example 11 | First surface | SiOx | A-1 | B-1 | C-2 | 80 | 2.0 | Sufficient | 0.00 | 0.24 | 0.005 | 96% | Non-processing | High |
| | Second surface | SiN | A-1 | B-1 | C-2 | 27 | - | - | 0.95 | 3.70 | 0.074 | 20% | Processing | |
| Example 12 | First surface | Si | A-2b | B-1 | C-1 | 81 | 4.1/5.2 | Sufficient | 0.00 | 0.18 | 0.004 | 97% | Non-processing | High |
| | First surface | SiOx | A-2b | B-1 | C-1 | 87 | 4.4/5.7 | Sufficient | 0.00 | 0.00 | 0.000 | 100% | | |
| | Second surface | SiN | A-2b | B-1 | C-1 | 16 | - | - | 2.40 | 5.20 | 0.104 | 5% | Processing | |
| | Second surface | SiGe | A-2b | B-1 | C-1 | 13 | - | - | 1.50 | 3.50 | 0.063 | 15% | | |
| Reference Example 3 | | Si | A-2b | - | - | 5 | | | 2.18 | 4.20 | 0.084 | | | |
| | | SiOx | A-2b | - | - | 5 | | | 2.85 | 5.50 | 0.110 | | | |
| | | SiN | A-2b | - | - | 12 | | | 2.40 | 5.50 | 0.110 | | | |
| | | SiGe | A-7b | - | - | 7 | | | 1.73 | 3.70 | 0.074 | | | |

### (Measurement of water contact angle (S))

A water contact angle (S) immediately before the film formation test was measured by the following method.

First, each substrate was immersed in pure water for 1 minute and then in IPA (25°C) for 1 minute. Thereafter, the substrate was taken out, and air was blown to remove IPA, whereby the substrate was dried.

Next, the substrate was placed horizontally with a desired surface facing upward, and a water droplet of 2 µl of pure water was placed on the surface.

Next, in accordance with JIS R 3257:1999 "Testing method of wettability of surface of glass substrate", an angle (water contact angle) formed by a water droplet and the substrate was measured with a contact angle meter (manufactured by Kyowa Interface Science Co., Ltd.: CA-X type). In addition, the temperature during the measurement was set to room temperature (25°C) .

It is noted that in Table 3, in this case, the water contact angle (°) of the first surface was denoted as S1, the water contact angle (°) of the second surface was denoted as S2, and a value of (S1 - S2)/S2 was calculated using S1 and S2.

### (Evaluation of difference in water repellency)

The difference in water repellency on the substrate surface immediately before the film formation by ALD was evaluated based on the following evaluation standards by using the value of "(S1 - S2)/S2" measured above.

Sufficient: A case where (S1 - S2)/S2 is 1.0 or more Insufficient: A case where (S1 - S2)/S2 is less than 1.0

(Measurement of amount of film formation, calculation of speed of film formation, and amount of suppression of film formation)

Using an ellipsometer (manufactured by J. A. Woollam Company, M2000-DI) and an XPS device (manufactured by ULVAC-PHI. Inc., PHI 5000 VersaProbe II), the amount of film formation (nm) for titanium oxide on the substrate was calculated. In addition, the amount of film formation was measured for each of the case where the film formation by ALD was carried out for 25 cycles and the case where the film formation by ALD was carried out for 50 cycles.

Based on the obtained amount of film formation, the speed of film formation (nm/cycle) and the amount of suppression of film formation (%) were calculated.

The speed of film formation was calculated from the slope of each of the amount of film formations at 25 cycles and 50 cycles.

The amount of suppression of film formation was calculated from the following expression.

Amount of suppression of film formation (%) = (speed of film formation of corresponding reference example - speed of film formation of example or comparative example)/(speed of film formation of corresponding reference example) × 100 ···

### (Expression)

The "corresponding reference example" is a reference example in which a substrate having the same surface composition is used and the same treatment A is carried out, and for example, a reference example corresponding to Examples 1 and 3 to 10 in which the substrate is SiOx is Reference Example 1 in which the substrate is SiOx.

### (Selectivity of film formation)

The selectivity of film formation (selective processability) in each of Examples, Comparative Examples, and Reference Examples was evaluated based on the following standards by using the above-described amount of suppression of film formation.

High selectivity (high): A case where, among the substrate samples in the film forming device, a difference in the amount of suppression of film formation between a substrate surface (having the smallest amount of suppression of film formation), which is a processing target, and a substrate surface, which is another target serving as a non-processing target, is 50% or more

Low selectivity (Low): A case where, among the substrate samples in the film forming device, a difference in the amount of suppression of film formation between a substrate surface (having the smallest amount of suppression of film formation), which is a processing target, and a substrate surface, which is another target serving as a non-processing target, is less than 50%

From the above, since in each of Examples, the speed of film formation was slowed down by 90% or more in the substrate having high water repellency on the surface in a case where the substrate of the reference example which does not have water repellency on the surface was used as a standard, the results shown were such that the film formation of an ALD film of titanium oxide or the like could be suppressed. In addition, since in the substrate in which the water repellency is selectively reduced by the removal treatment C, a comparable speed of film formation is achieved in a case where the substrate of the reference example which does not have water repellency on the surface is used as a standard, there is no problem in practical use, and it is possible to carry out the film formation of an ALD film of titanium oxide or the like.

In addition, in a case where each of Examples and each of corresponding Comparative Examples were compared, it was found that all of Comparative Examples show such a tendency that the film formation tends to be suppressed on the second surface which is a processing target, although the suppression was not comparable to the suppression in Examples. This is presumed to be because the water repellent film or the compound derived from the silylating agent is present on the second surface since the above-described removal treatment C is not carried out, and as a result, the film formation is partially suppressed. It was found that since by the removal treatment C in Examples, the water repellency of the substrate surface (second surface), which is a processing target, can be selectively reduced with respect to the substrate surface (first surface), which is a non-processing target, the difference in the amount of suppression of film formation between these can be widened, and as a result, the selectivity of film formation (selective processability) is increased.

From the above results, it was shown that the substrate processing method in each of Examples makes it possible to selectively reduce the water repellency on the predetermined surface in a substrate having two or more kinds of Si-based surfaces, as compared with the corresponding substrate of each of Comparative Examples, which makes it possible to increase the selective processability in a case of ALD film formation or the like.

This application claims priority based on Japanese Patent Application No. 2022-090143 filed on June 2, 2022, and all contents of the disclosure are incorporated herein.

### REFERENCE SIGNS LIST

1 substrate
1a substrate surface
11 first surface
12 second surface
20 silylating agent, silylation composition
21 water repellent film
22 water repellent film
30 removing agent

## Claims

1. A substrate processing method comprising:
a preparation step of preparing a substrate that has, on a surface thereof, a first surface which contains Si and a second surface which has a different chemical composition from the first surface and which contains Si;
a surface modification step of carrying out a silylation treatment of bringing a silylating agent into contact with the first surface and the second surface and then carrying out a water repellency adjustment treatment of selectively decreasing water repellency of the second surface with respect to the first surface; and
a processing step of selectively carrying out a processing treatment with respect to the second surface after the surface modification step.

2. The substrate processing method according to Claim 1,
wherein in the surface modification step, a pretreatment is carried out before the silylation treatment, and
wherein the pretreatment includes a treatment A-1 of removing a natural oxidation film on at least the first surface and/or a treatment A-2 of bonding OH to at least a part of Si on the first surface.

3. The substrate processing method according to Claim 2,
wherein the treatment A-2 is a treatment A-2a of bringing an active species containing an oxygen element and/or a gas containing an oxygen element into contact with at least the first surface, or a treatment A-2b of bringing an oxidizing agent containing an oxygen element into contact with at least the first surface.

4. The substrate processing method according to Claim 3,
wherein the treatment A-2a is at least one selected from the group consisting of a plasma treatment using a plasma containing an oxygen element, a UV/O₃ treatment, and a gas treatment of carrying out exposure to a gas containing an oxygen element.

5. The substrate processing method according to Claim 3,
wherein the oxidizing agent includes a solution containing H₂O₂, and/or ozone water.

6. The substrate processing method according to any one of Claims 1 to 5,
wherein the water repellency adjustment treatment includes a removal treatment of removing, by using a removing agent, at least a part of compounds derived from the silylating agent, which are chemically or physically bound to the second surface.

7. The substrate processing method according to Claim 6,
wherein the removing agent includes at least one selected from the group consisting of ammonia, an organic amine, a quaternary ammonium hydroxide, and hydrogen fluoride.

8. The substrate processing method according to any one of Claims 1 to 7,
wherein in a case where a value of a water contact angle on the first surface is denoted as S1 and a value of a water contact angle on the second surface is denoted as S2 immediately before the processing step after the surface modification step, (S1 - S2)/S2 is 1.0 or more.

9. The substrate processing method according to any one of Claims 1 to 8,
wherein in a case where the first surface is silicon oxide, the second surface is silicon, or alternatively, a compound formed between Si and at least one selected from the group consisting of N, C, and a metal element, or an oxide of the compound,
in a case where the first surface is silicon, the second surface is a compound formed between Si and at least one selected from the group consisting of N, C, and a metal element, or an oxide of the compound, and
in a case where the first surface is a compound formed between Si and at least one selected from the group consisting of N and C, or an oxide of the compound, the second surface is a compound formed between Si and a metal element, or an oxide of the compound.

10. The substrate processing method according to any one of Claims 1 to 9,
wherein in the processing step, the processing treatment includes a film forming treatment of forming a film on the second surface by an atomic layer deposition method and/or an etching treatment of etching the second surface.

11. The substrate processing method according to any one of Claims 1 to 10,
wherein in the silylation treatment, the silylating agent is used, or a silylation composition containing the silylating agent is used.

12. The substrate processing method according to Claim 11, wherein the silylation composition contains at least one of a solvent, a dilution gas, or a catalytic compound.

13. The substrate processing method according to any one of Claims 1 to 12,
wherein the surface modification step includes a cleaning treatment of cleaning at least a part of the second surface with a cleaning agent.

14. The substrate processing method according to Claim 13,
wherein the cleaning agent includes an aqueous cleaning solution and/or a rinsing solution.

15. A substrate manufacturing method comprising:
a step of obtaining a substrate on which each step in the substrate processing method according to any one of Claims 1 to 14 has been carried out.
